# EUROPEAN PATENT APPLICATION

(11) **EP 4 550 193 A1**
(43) Date of publication of application: **07.05.2025**
(21) Application number: 23830458.8
(22) Date of filing: 29.06.2023
(51) Int. Cl.: G06F 30/10, G06Q 50/04, G06F 30/20, G06F 9/54, G06F 119/12

(54) **TWINNING METHOD FOR CURRENT STATE OF TARGET OBJECT, SUBSCRIPTION METHOD AND SYSTEM**

(30) Priority: 30.06.2022 CN 202210760272; 30.06.2022 CN 202210763041
(71) Applicant: Beijing Wellintech Co., Ltd., Beijing 100086 (CN)
(72) Inventor: LIN, Wei, Beijing 100086 (CN)
(74) Representative: Cabinet Nony
(86) International application number: PCT/CN2023/104171
(87) International publication number: WO 2024/002294

(57) **Abstract**

The present disclosure relates to the technical field of digital twinning, and discloses a twinning method for a current state of a target object, a subscription method and a system. The twinning method comprises: for a currently existing target object, and at least one sub-target object forming the target object, respectively establishing a target object model and at least one sub-target object model; and establishing an association relationship between the target object model and the at least one sub-target object model. Thus, the effect of simplifying existing twinning methods for target objects can be achieved.

## Description

### Cross-Reference to Related Applications

This application claims priority to Chinese Patent Application No. 202210760272.6, filed with the China National Intellectual Property Administration on June 30, 2022 and entitled "Twinning method for current state of target object, subscription method and system", and priority to Chinese Patent Application No. 202210763041.0, filed with the China National Intellectual Property Administration on June 30, 2022 and entitled "Twinning method for current state of real-time event, subscription method and system", both of which are hereby incorporated by reference in their entireties.

### Technical Field

This disclosure relates to the technical field of digital twins, especially a twin method, subscription method and system for the current state of a target object.

### Background

The existing method of building a digital twin model usually analyzes the parameters of the model through simulation, which can be transferred to a full three-dimensional geometric model defined by the product, and then transferred to the digital production line to be processed into a real physical product, which is reflected through the online digital inspection/measurement system into the product definition model, and then fed back into the simulation analysis model. Relying on digital twins, all data models can communicate in two directions. Therefore, the status and parameters of the real physical product are fed back to the digital models, making the digital models in each link of the life cycle consistent, thus enabling dynamic and real-time assessment of the current and future performance of the system. Functionality and performance. Building a digital twin model requires generating or extracting models in each scenario, then building an action library, and combining each scenario with the corresponding model and corresponding actions to build a digital twin scenario.

In the process of implementing the present disclosure, it is found that there are at least the following problems in the related art: in actual production or application, the digital twin method that combines multiple models and multiple scenarios needs to occupy a large amount of system resources, increase the operating load of the system, and then increased production costs are not conducive to industrial application.

### Summary

To this end, embodiments of the present disclosure provide a twin method, subscription method and system for the current state of a target object, which can solve the technical problem that the existing digital twin method is complex and not suitable for industrial applications. The specific technical solution content is as follows.

In the first aspect, some embodiments of the present disclosure provide a twinning method of a current state of a target object, including:
establishing a target object model and at least one sub-target object model respectively for a target object and at least one sub-target object that constitutes the target object;
establishing an association relationship between the target object model and at least one sub-target object model.

Further, the association relationship is a parent-child relationship, the target object model in the parent-child relationship is a parent model, and a sub-target object model in the parent-child relationship is a child model.

Further, in the parent-child relationship, the target object model is a unique parent model of the sub-target object model.

Further, the target object is a target physical entity, the target object model is a target entity model; the sub-target object is a part physical entity, and the sub-target object model is a part entity model; both the target entity model and the part entity model includes a time attribute; assigning a value of the time attribute in the target entity model and at least one part entity model with a current moment.

Further, both the target entity model and the part entity model include a spatial attribute describing a spatial size of the target entity model or the part entity model.

Further, the spatial attribute is described by a spatial range for describing a geometric range formed by coordinate values of the target entity model or the part entity model in a coordinate system; a spatial range of the part entity model of the part physical entity with the parent-child relationship is less than or equal to a spatial range of the target entity model of the target physical entity.

Further, the target entity model and the part entity model further include a unique identifier for uniquely mapping to a corresponding target entity model or a corresponding part entity model.

Further, the method further includes: in the target entity model of the target physical entity, establishing a first coordinate system, wherein an origin of the first coordinate system remains fixed relative to a spatial position of the target entity model; a value of the spatial attribute of the part entity model of the part physical entity adopt the first coordinate system as a reference coordinate system; in a case that the target entity model moves, the part entity model that includes the parent-child relationship with the target entity model moves along with the target entity model.

Further, the method further includes: in the target entity model of the target physical entity, establishing a first coordinate system, wherein an origin of the first coordinate system remains fixed relative to a spatial position of the target entity model; establishing a second coordinate system corresponding to the part entity model based on the first coordinate system; wherein there is a relative positional relationship between the first coordinate system and the second coordinate system; in a case that the target entity model moves, the part entity model that includes the parent-child relationship with the target entity model moves accordingly based on the spatial range of the part entity model and the second coordinate system with a relative positional relationship.

Further, the part entity model further includes a position attribute; the position attribute is used for describing any spatial range of the part entity model other than the spatial range of the part entity model within a spatial range of the target entity model that includes the parent-child relationship with the part entity model.

Further, in a case of the part entity model moving, modifying a value of the position attribute of the part entity model to be a unique identifier of another part entity model corresponding to a spatial range to which the part entity model needs to be moved.

Further, both the target entity model and the part entity model include shape information and posture information, and the shape information is coordinate data describing a shape of the target entity model in the first coordinate system or coordinate data describing a shape of the part entity model in the second coordinate system; the posture information describes data describing a rotation of the target entity model in the first coordinate system or data describing a rotation of the part entity model in the second coordinate system.

Further, the method further includes: after the target entity model is deleted, disassociating the part entity model that includes the parent-child relationship with the target entity model from the target entity model; or in a case that the part entity model moves outside a spatial range of the target entity model, disassociating the part entity model from the target entity model.

Further, both the target entity model and the part entity model further includes member information for describing difference information of the target entity model or the part entity model.

Further, the target object is a current event, and the target object model is a current event model; the sub-target object is a sub-event, and the sub-target object model is a sub-event model.

both the current event model and the sub-event model include at least a time attribute for describing a start time and a first moment, the start time of the current event model is no later than the start time of the sub-event model; the first moment includes the current moment, or represents a duration from the start time to the current moment.

Further, the duration describes a duration of a the current event model or a duration of the sub-event model, and the duration of the current event model that includes the parent-child relationship with the sub-event model is not less than the duration of the sub-event model.

Further, both the current event model and the sub-event model further include an entity identifier for describing an entity object associated with the current event model or the sub-event model.

Further, both the current event model and the sub-event model further include member information for describing difference information of the current event model or difference information of the sub-event model.

Further, both the current event model and the sub-event model further include a type for describing a category of the current event model described by the member information or a category of the sub-event model described by the member information; wherein the category is set based on the member information.

Further, the target object is a current event, and the target object model is a current event model; the sub-target object is a sub-event, and the sub-target object model is a sub-event model; the method further includes: for the current event model and each sub-event model, constructing at least one current event record of the current event model and at least one sub-event record of the sub-event model, wherein specified data information of the current event model is recorded in the at least one current event record, specified data information of the sub-event model is recorded in the at least one sub-event record; constructing different current event records for member information of different state values of a same current event model; constructing different sub-event records for member information of different state values of a same sub-event model; an event record includes a time attribute for describing a start time and a first moment; the first moment includes a current moment or a duration from the start time to the current moment, and the start time of the current event record is no later than the start time of the sub-event recording.

Further, the current event record includes an associated relationship with any sub-event record.

Further, both the current event record and the sub-event record further include an event record identifier for uniquely identifying the current event record or the sub-event record.

Further, both the current event model and the sub-event model further include a spatial attribute, and the spatial attribute describes a geographical location or geographic range where a corresponding current event model or sub-event model occurs.

Further, the geographical location where the sub-event model occurs is within a predetermined range of the geographical location where the current event model occurs, or a geographical range where the sub-event model occurs is within a geographical range where the current event model occurs.

In the second aspect, some embodiments provide a method for subscribing to a current state of a target object, including: establishing a target object model and at least one sub-target object model respectively for a target object and at least one sub-target object that constitutes the target object; in a case that a state of the sub-target object model changes, receiving by a subscriber, change information of the sub-target model associated with the target object model.

Further, the target object is a target physical entity, and the target object model is a target entity model; the sub-target object is a part physical entity, and the sub-target object model is a part entity model; both the target entity model and the part entity model include a time attribute; assigning a value of the time attribute of the target entity model and at least one part entity model to a current moment; before the receiving by the subscriber, the change information of the sub-target model associated with the target object model, the method further includes: establishing an association relationship between the target entity model and at least one part entity model.

Further, the method further includes: after at least one part entity model associated with the target entity model is created, receiving by the subscriber, creation information of the part entity model associated with the target entity model.

Further, in a case that the state of the part entity model changes, receiving by the subscriber, the change information of the part entity model associated with the target entity model, includes: in a case that the state of the part entity model changes, querying whether there is a subscription item of the target entity model that is associated with the part entity model; releasing the change information of the part entity model in response to there being the subscription item.

Further, the state of the part entity model changing, includes any of the following situations: an attribute of the part entity model is modified, or the part entity model is deleted from the target entity model associated with the part entity model.

Further, the method further includes: for the target entity model, obtaining all association relationships existing in the target entity model, and querying all part entity models associated with the target entity model by using the all association relationships; for the part entity model, obtaining all association relationships existing in the part entity model, and querying the target entity model associated with the part entity model and other part entity models associated with the target entity model by using the all association relationships.

Further, the target object is a target physical entity, and the target object model is a target entity model; the sub-target object is a part physical entity, and the sub-target object model is a part entity model; the target entity model and the part entity model at least include a spatial range for describing a range of the target entity model or the part entity model formed by coordinate values in a coordinate system; in a case that the state of the sub-target object model changes, receiving by the subscriber, the change information of the sub-target model associated with the target object model, includes: in a case that a spatial range of the part entity model overlaps with a spatial range of the target entity model, receiving by the subscriber, the change information of the part entity model.

Further, in a case that the spatial range of the part entity model overlaps with the spatial range of the target entity model, receiving by the subscriber, the change information of the part entity model within the target entity model, includes: in a case that the spatial range of the part entity model first overlaps the spatial range of the target entity model, receiving by the subscriber, information about the part entity model moving into the target entity model.

Further, in a case that the spatial range of the part entity model overlaps with the spatial range of the target entity model, receiving by the subscriber, the change information of the part entity model within the target entity model, includes: in a case that the part entity model changes, querying the spatial range of the target entity model corresponding to a subscription item of all spatial ranges, and determining whether the spatial range of the part entity model overlaps with the spatial range of the target entity model corresponding to the subscription item of the all spatial ranges; releasing the change information of the part entity model of in response to the spatial range of the part entity model overlapping with the spatial range of the target entity model corresponding to the subscription item of the all spatial ranges.

Further, the part entity model changing includes any of the following situations: an attribute of the part entity model within the spatial range of the target entity model is modified, or the part entity model is moved out of the spatial range of target entity model.

Further, the method further includes: for the target entity model, query all part entity models within the spatial range of the target entity model according to the spatial range of the target entity model; for the part entity model, querying the target entity model whose spatial range includes the spatial range of the part entity model, and/or querying other part entity models included in the spatial range of the target entity model according to the spatial range of the part entity model.

Further, the target object is a current event, and the target object model is a current event model; the sub-target object is a sub-event, and the sub-target object model is a sub-event model; both the current event model and the sub-event model include at least a time attribute for describing a start time and a first moment, and the start time of the current event model is earlier than the start time of the sub-event model associated with the current event model; the first moment includes a current moment or a duration from the start time to the current moment; before the receiving by the subscriber, the change information of the sub-target model associated with the target object model, the method further includes: establishing an association relationship between the current event model and at least one sub-event model.

Further, the method further includes: after at least one sub-event model associated with the current event model is created, receiving by the subscriber, creation information of the sub-event model associated with the current event model.

Further, in a case that a state of the sub-event model changes, receiving by the subscriber, the change information of the sub-event model associated with the current event model, includes: in a case that the state of the sub-event model changes, querying whether there is a subscription item of the current event model associated with the sub-event model; releasing the change information of the sub-event model in response to there being the subscription item of the current event model associated with the sub-event model.

Further, the state of the sub-event model changing includes any of the following situations: an attribute of the sub-event model is modified, or the sub-event model is deleted from the current event model associated with the sub-event model.

Further, the method further includes: for the current event model and each sub-event model, constructing at least one current event record of the current event model and at least one sub-event record of the sub-event model, wherein specified data information of the current event model is recorded in the at least one current event record, specified data information of the sub-event model is recorded in the at least one sub-event record; constructing different current event records for member information of different state values of a same current event model; constructing different sub-event records for member information of different state values of a same sub-event model; in a case that the at least one sub-event record is added, modified or deleted and/or the at least one current event record is added, modified or deleted, receiving by the subscriber, change information of all current event records of the current event model and/or change information of all sub-event records of the sub-event model.

Further, the method further includes: for the current event model, obtaining all association relationships of the current event model, and querying all sub-event models associated with the current event model by using the all association relationships; for the sub-event model, obtaining all association relationships of the sub-event model, and querying the current event model associated with the sub-event model and other sub-event models associated with the current event model, by using the all association relationships.

Further, the method further includes: creating an index based on the association relationships of the current event model and/or sub-event models, or based on the association relationships and an attribute value of at least one attribute, and querying a current event model and/or a sub-event model corresponding to the attribute value.

Further, the method further includes: querying the current event model or the sub-event model, and associating all event records of queried current event model or queried sub-event model.

Further, the current event record includes an association relationship with any sub-event record.

Further, both the current event record and the sub-event record further include an event record identifier, and the method further includes: querying all sub-event records associated with the current event record by using the event record identifier of the current event record; or querying the current event record associated with any sub-event record by using the event record identifier of the any sub-event record.

In the third aspect, some embodiments of the present disclosure provide a twinning system of a current state of a target object, including: a model building module configured to establish a target object model and at least one sub-target object model respectively for a target object and at least one sub-target object that constitutes the target object; an association-relationship establishment module configured to establish an association relationship between the target object model and the at least one sub-target object model.

In the fourth aspect, some embodiments of the present disclosure provide a system for subscribing to a current state of a target object, including: a model building module configured to establish a target object model and at least one sub-target object model respectively for a target object and at least one sub-target object that constitutes the target object; a releasing module configured for a subscriber to receive change information of the sub-target model associated with the target object model in response to a state of the sub-target object model changing.

In the fifth aspect, some embodiments of the present disclosure provide a computer-readable storage medium, storing a computer program, and in response to the computer program being executed by a processor, steps of the method described in any one of the first aspect and the second aspect.

To sum up, compared with the existing technology, the beneficial effects brought by the technical solutions provided by the embodiments of the present disclosure at least include followings.

When the target object is a target physical entity, the entity model is described through the attributes in the entity model data structure. The time attribute value describes the current time when the entity model is called to view, and the industrialization is described by the association between the target entity model and the part entity model. The mutual relationship between physical entities in production realizes coupling between physical entities. There is no need to establish multiple models and multiple scenarios to realize digital twins of physical objects, which can meet the needs of industrialized production, reduce the system resources that need to be occupied, reduce operating load of the system and reduce the cost of the system, thereby reducing production costs. It is suitable for digital twins under a variety of equipment configurations, simplifying the twin process and reducing the complexity of digital twins. The model associated with the part entity model or the target entity model is subscribed by the association relationship. When a certain physical entity subscribed changes, the impact of the change of the physical entity on other associated physical entities can be obtained through the association relationship to meet the needs of industrialized production. Query the model associated with the part entity model or the target entity model based on the association relationship to quickly query a certain model and other models related to the model. In industrial applications, you can know in time the impact of changes in a certain physical entity on other models. The influence of production factors meets the needs of industrialized production applications.

When the target object is the current event, an association relationship is established between the current event model and the sub-event model to express the intricate relationship between events, thereby reducing the complexity of the event model twins and simplifying the intricate relationship between events as The relationship between start times simplifies the logic of establishing event models, and makes the event model establishment method of present disclosure suitable for event model twins in various fields, such as industrial production, medical care, aerospace, etc. The event twin method of present disclosure is simple, and it can describe the relationship between events, making it easier for engineers to create event models.

### Brief Description of Figures

FIG. 1 is a schematic flowchart of a twinning method for the current state of an entity provided by an embodiment of the present disclosure;
FIG. 2 is the first schematic flowchart of a twinning method for the current state of an entity provided by another embodiment of the present disclosure;
FIG. 3 is the second schematic flowchart of a twinning method for the current state of an entity provided by another embodiment of the present disclosure;
FIG. 4 is a schematic flowchart of a method for subscribing to the current state of an entity provided by an embodiment of the present disclosure;
FIG. 5 is the first schematic flowchart of a method for subscribing to the current state of an entity provided by another embodiment of the present disclosure;
FIG. 6 is the second schematic flowchart of a method for subscribing to the current state of an entity provided by another embodiment of the present disclosure;
FIG. 7 is the third schematic flowchart of a method for subscribing to the current state of an entity provided by another embodiment of the present disclosure;
FIG. 8 is the fourth schematic flowchart of a method for subscribing to the current state of an entity provided by another embodiment of the present disclosure;
FIG. 9 is the fifth schematic flowchart of a method for subscribing to the current state of an entity provided by another embodiment of the present disclosure;
FIG. 10 is a schematic flowchart of a twinning method for the current state of real-time events provided by an embodiment of the present disclosure;
FIG. 11 is a schematic flowchart of a twinning method for the current state of real-time events provided by another embodiment of the present disclosure;
FIG. 12 is a schematic flowchart of a method for subscribing to the current state of real-time events provided by an embodiment of the present disclosure;
FIG. 13 is a schematic flowchart of a method for subscribing to the current state of real-time events provided by another embodiment of the present disclosure.

### Detailed Description

The specific embodiments are only explanations of the present disclosure, and are not limitations of the present disclosure. After reading the specification, those skilled in the art can make modifications to the embodiments without creative contribution as needed, but the preset disclosure are protected by patent law as long as the modifications are within the scope of claims of the present disclosure.

In order to make the purpose, technical solutions and advantages of the embodiments of the present disclosure clearer, the technical solutions in the embodiments of the present disclosure will be clearly and completely described below in conjunction with the drawings in the embodiments of the present disclosure. Obviously, the described embodiments are part of the embodiments of this disclosure, not all of them. Based on the embodiments in this disclosure, all other embodiments obtained by those of ordinary skill in the art without creative efforts fall within the scope of protection of this disclosure.

In addition, the term "and/or" in this disclosure is only an association relationship describing related objects, indicating that there can be three relationships, for example, A and/or B, which can mean: A exists alone, and A and B exist simultaneously, and B exists alone. In addition, the character "/" in this disclosure, unless otherwise specified, generally indicates that the related objects are in an "or" relationship.

Some embodiments of this disclosure provide a twinning method for the current state of a target object. The method includes the following steps 1 and 2:
Step 1: Establishing a target object model and at least one sub-target object model for the currently existing target object and at least one sub-target object that constitutes the target object;
Step 2: Establishing an association between the target object model and at least one sub-target object model.

In some embodiments, the association relationship is a parent-child relationship, the target object model in the parent-child relationship is the parent model, and the sub-target object model in the parent-child relationship is the child model. In the parent-child relationship, the target object model is the only parent model of the sub-target object model.

Some embodiments of the present disclosure further provide a method for subscribing to the current state of a target object. The method includes the following steps (1) and (2):
Step (1): Establishing a target object model and at least one sub-target object model for the currently existing target object and at least one sub-target object that constitutes the target object;
Step (2): When the state of the sub-target object model changes, receiving by a subscriber the change information of the sub-target model associated with the target object model.

It should be noted that the twinning method and subscription method of the current state of the target object provided by the embodiments of present disclosure can be implemented for entity objects or events. When the twinning method is implemented for an entity, the target object can be the target physical entity. When the twinning method is implemented for an event, the target object can be the current event.

Digital twins have many applications in industrialization, such as production process simulation, digital production lines, key indicator monitoring and process capability assessment, etc. The physical entities are described using virtual numbers. The physical entities exist in physical space, and physical entities also occupy physical space. The entity objects are physical entities that exist in reality, such as generating equipment, factories, products, etc. Events are events that are triggered by the entity object itself or are generated by the entity object or are about to be executed by the entity object. Events can be alarm events, leave processes, production orders, workflows, etc.

The embodiments of the present disclosure will be further described in detail below with reference to the accompanying drawings in the description from the perspectives that the target object is the target physical entity, the sub-target object is the part physical entity, and the target object is the current event and the sub-target object is the sub-event.

In one implementation, when the target object is a target physical entity, the twinning method and subscription method of the current state of the target object provided by the embodiments of the present disclosure can be a twinning method and subscription method of the current state of the entity. Therefore, in the explanation as follows, the twinning method and subscription method of the current state of an entity will refer to the twinning method and subscription method of the current state of the target object when the target object is the target physical entity.

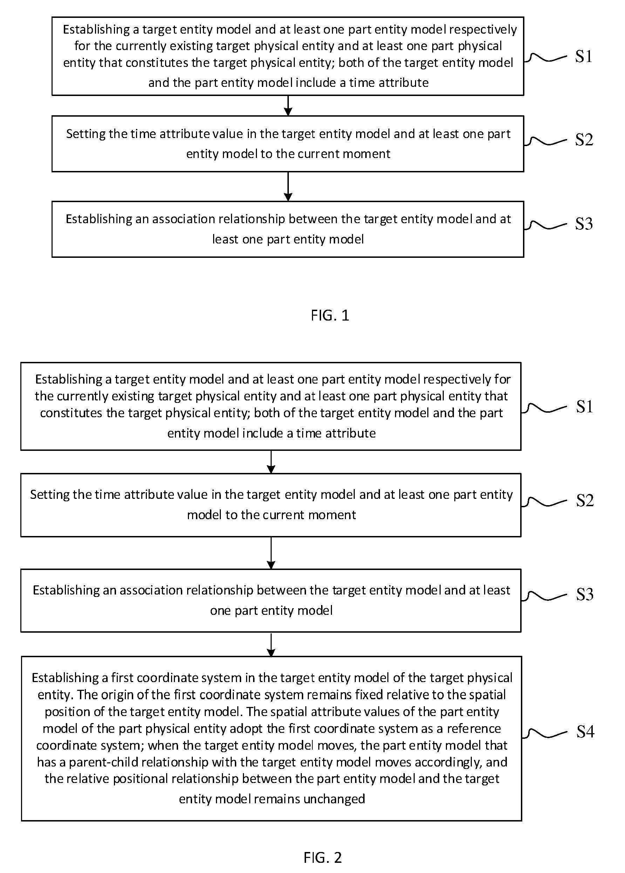

Referring to FIG. 1, in an embodiment of the present disclosure, a twinning method of the current state of an entity is provided. The main steps of the method are described as follows:
S1: Establishing a target entity model and at least one part entity model respectively for the currently existing target physical entity and at least one part physical entity that constitutes the target physical entity; both of the target entity model and the part entity model include a time attribute;
S2: Setting the time attribute value in the target entity model and at least one part entity model to the current moment;
S3: Establishing an association relationship between the target entity model and at least one part entity model.

In this embodiment, the concept of object as space is proposed, the physical entity is abstracted and described by space, and an entity model corresponding to the physical entity is established (in the current and following descriptions, it refers to the target entity model and the part entity model), describing the spatial positional relationship between physical entities through the association relationship between entity models, and then realizing the description of the association between different physical entities in actual industrial applications to meet the construction needs of large-scale industrial lines.

This embodiment proposes the concept that objects are spaces, that is, when modeling, not focus on the external manifestations, geometric textures, etc. of physical entities, but express physical entities in space, simplifying the relationship between objects into the relationship between space and space relationship. Taking one of the specific implementation methods as an example, when modeling a physical entity, the physical entity is modeled according to the actual spatial range of the physical entity, and the physical entity is described by space. The shape of the space can be arbitrary shape. The present disclosure does not pay attention to the external representation of space when modeling. Instead, it uses a simple structure to describe the physical entity. It proposes a simple method to realize the digital twin of the physical entity and is suitable for twinning of different physical entities in industrial production.

When performing digital twins, physical entities can be twinned based on the fact that physical entities are physical spaces. The physical entities can be directly modeled based on the concept of objects as spaces, without the need to build an intermediate model of the physical entities. For example, in factory applications, factory-workshop-production line-equipment, etc. are constructed from physical entities in any scene such as parts assembly as a whole, etc., and the target entity model corresponding to the factory is then constructed based on the relationship between the physical entity and the physical entity of the parts attached to the physical entity. Then the target entity model corresponding to the workshop is established. By establishing the association between the target entity model corresponding to the factory and the target entity model corresponding to the workshop, the relationship between the physical entities in the factory is described. In the association between the target entity model corresponding to the factory and the target entity model corresponding to the workshop, the target entity model corresponding to the workshop is the part entity model of the target entity model corresponding to the factory. In the relationship between the workshop and the production line, the production line is the parts attached to the workshop, that is, the target entity model corresponding to the production line is the part entity model associated with the target entity model corresponding to the workshop.

In this embodiment, in addition to the affiliation relationship, the association relationship between the physical entity and the part physical entity can also be any one or two or more association relationships that can be established between physical entities, such as management relationship, spatial inclusion relationship, etc. This will not be described in detail. In this embodiment, the method of establishing an association relationship is to set a tag association between the target entity model and the part entity model. In other embodiments of present disclosure, other implementation methods may also be used, such as constructing a coordinate system. The space of the parent model in the coordinate system includes the space of the child model, etc., which will not be described in detail here.

The target entity model is associated with at least one part entity model. For example, if there are more than two workshops under a factory, digital twins are performed on all workshops, and an association relationship between the part entity models of the workshops that are affiliated with the factory and the target entity models corresponding to the factory.

For a directly constructed entity model, in this embodiment, the entity model is a computer data structure that maps data in the physical entity in real, and different data elements (such as attributes) in the data structure are used to describe the physical entity. In the physical entity in real, the data can be obtained by sensors or maintained by technicians, etc., which will not be described in detail here.

The data element of the entity model includes a time attribute, which describes the current moment of the entity model, that is, the time attribute value is the current moment. In this embodiment, physical entities are described through the time attribute. In industrial applications, for physical entities in industrial applications, when performing applications such as monitoring, the various states of the physical entities at the current time can be learned.

Specifically, in this embodiment, when the user calls the entity model, the entity model obtains the current time of the computer as the time attribute value. In other embodiments of the present disclosure, other methods can also be used to obtain the current time of the entity model, such as maintenance by background technical personnel, etc. will not be described in detail here.

In this embodiment, the data elements of the entity model can be added according to the needs of the application industry, such as spatial attributes, location attributes, coordinate information, posture information, unique identifiers, etc., which will not be described in detail here.

In this embodiment, the method of establishing an association relationship between the target entity model and the part entity model at least includes:
1. Adding data elements describing the part entity model with the association relationship in the computer data structure of the target entity model and/or adding data elements describing the target entity model with the association relationship in the computer data structure of the part entity model;
2. Establishing a coordinate system so that the spatial range formed by the coordinate values of the target entity model in the coordinate system includes the spatial range formed by the coordinate values of the part entity model in the same coordinate system.

The present disclosure establishes a computer data structure by abstracting the target entity model into a space. When establishing a data twin, there is no need to pay attention to the shape, texture and other information of the physical entity, so as to simplify the logic of physical entity twins and be applicable to all things twins. Moreover, the present disclosure establishes an association relationship between the target entity model and the part entity model for describing the relationship between the physical entities by the association relationship, realizing the linkage and coupling between the physical entities, which is suitable for industrialized production. The present disclosure satisfies the purpose of monitoring physical entities and obtaining the real-time state of physical objects during industrialized production by setting time attributes.

The present disclosure does not need to build multiple models and multiple scenarios to realize the digital twin of the physical objects. The physical model is described through the data elements of the physical model to meet the needs of industrial production, reduce the system resources that the model needs to occupy, and reduce the operating load of the system, thereby reducing production costs, being suitable for digital twins in a variety of situations, and simplifying the digital twin process. Moreover, the twinning method of present disclosure is relatively intuitive, and users can directly twin the relationship between the target entity models in reality according to the actual spatial relationship of the corresponding physical entities.

Optionally, in another embodiment, the association relationship is a parent-child relationship. The target entity model with the parent-child relationship is the parent model, and the part entity model is the child model.

Specifically, in the parent-child relationship, the child can inherit some characteristics of the parent, that is, the child can inherit some of the attributes and methods of the parent. Reflected at the software program level, the amount of code can be greatly reduced by adopting a parent-child relationship, and the parent-child relationship is a bidirectional one-to-many relationship, which is suitable for production applications and needs to be reflected in the relationship between the physical entity and at least one associated part physical entity.

For example, in this embodiment, assuming that the relationship between the physical entity and the part physical entity is a spatial inclusion relationship, the part entity model with a parent-child relationship inherits the spatial position of the parent model, and the child model is within the spatial range of the parent model. In another implementation, if the part entity model A is managed by another part entity model B, then the child model that has a parent-child relationship with the part entity model A is managed by the part entity model A and inherits the attributes managed by another part entity model B. In other implementations, there are other ways in which the parent-child relationship is reflected will not be described in detail here.

Optionally, in another implementation, the target entity model in the parent-child relationship is the only parent model for the part entity model.

Optionally, in another embodiment, both the target entity model and the part entity model are provided with spatial attributes, the spatial attributes describe the spatial range of the target entity model or the part entity model, and the spatial range describes the range of the target entity model or the part entity model formed by the coordinate values in the coordinate system.

The spatial range of the part entity model of the part physical entity with a parent-child relationship is less than or equal to the spatial range of the target entity model of the target physical entity.

Specifically, in this embodiment, for industrial applications, according to "object is space", the target entity model is simplified to use a space description in the established coordinate system to set the spatial range for both the target entity model and the part entity model. The spatial range is used to describe the spatial range occupied by the corresponding target entity model or part entity model in the coordinate system. The spatial range value is the coordinate value of the target entity model or part entity model in the coordinate system.

The spatial attribute is used to describe that the spatial range of the target entity model having a parent-child relationship includes the spatial range of the part entity model, for the target entity model and the part entity mode located in the same coordinate system. Based on the concept of object as space proposed in present disclosure, it can intuitively reflect the association relationship between the parent model and the child model, and the inheritance of the parent-child relationship is used to make the child model located within the spatial range of the parent model.

Further, in another embodiment, the target entity model and the part entity model also include a unique identifier, which is used to uniquely map to the corresponding target entity model or part entity model. Optionally, when establishing the association relationship between the target entity model and the part entity model, the parent-child association may be realized by setting the spatial attribute value of the part entity model as the unique identifier of the target entity model having a parent-child relationship. In this embodiment, different physical entities are distinguished by setting unique identifiers. Whether it is the target entity model or the part entity model, it has a unique identifier.

Specifically, when establishing an association relationship between the target entity model and the part entity model, the spatial attribute value of the entity model can be set to the unique identifier or coordinate value range of its parent model or the unique identifier of the child model. In this embodiment, taking that the spatial attribute value of the parent model is set as the unique identifier of the child model as an example, the spatial attribute value includes the unique identifiers of all child models associated with the parent model, which means that in the same coordinate system, the spatial range of the child model is within the spatial range of the parent model. When users call the target entity model to view relevant information of the target entity, the spatial attribute value can intuitively indicate the spatial inclusion relationship between the parent model and the child model. The spatial attribute and the time attribute can describe the current state of a physical entity. Building a factory model to meet the needs of industrial production.

In this embodiment, the spatial attribute value of the child model with a parent-child relationship is set as the unique identifier of the parent model. When a certain part entity model is called to view, the parent model of the certain part entity model can be directly found from the spatial attribute value, which facilitates search. Moreover, the spatial attribute value is used as the unique identifier, thereby establishing the spatial inclusion relationship between the parent model and the child model, simplifying the expression of the inclusion relationship between the parent model and the child model. In the process of establishing the digital model of the industrial production line, there is no need to pay attention to the actual relative position of the parent model and the child model, thereby simplifying the modeling process and being suitable for many digital twin scenarios.

Optionally, in another embodiment, the part entity model also includes a position attribute. The position attribute describes any spatial range of the part entity model excluding the spatial range of the part entity model within the spatial range of the target entity model having a parent-child relationship with the part entity model.

Specifically, in this embodiment, a coordinate system is established. The target entity model and the part entity model with a parent-child relationship are both in the same coordinate system. The target entity model is a space formed by coordinates in this coordinate system. The part entity model is also a space formed by the corresponding coordinates in the coordinate system. The spatial range of the target entity model includes the spatial range of the part entity model.

The method used in present disclosure to realize the movement of the part entity model within the spatial range of its parent model is to modify the position attribute value of the part entity model to the unique identifier of any other part entity model within the spatial range of the parent model. In industrialized production, the logic of entity model movement is simplified. There is no need to calculate the difference between the coordinates of the entity model that needs to be moved and the coordinates of the position to which it is moved, and the movement of the part entity model within its parent model can be described. Simplify the movement logic of entity models.

For example, in the production of a certain product in a factory, it needs to be processed by different production lines in the same workshop. In the digital model of the factory, the movement of the part entity model corresponding to the product moves within the spatial range of its parent model, can be achieved by modifying the position attribute of the part entity model to the unique identifier of the part entity model corresponding to the production line. Through simple position attribute values, the relationship between the product and the processing equipment during processing is expressed. In addition, it can also be applied in other scenarios, which will not be described here.

In another embodiment, in a preset modeling space, all movable positions in the modeling space can be represented by all unique identifiers, and other spaces other than the movable positions represented by the unique identifiers are ignored. The position attribute value of a part entity model is modified to the unique identifier of the part entity model other than itself within the parent model space to realize position movement and simplify the movement logic of the entity model. In other implementations, there may be other implementations, which will not be described again here.

Referring to FIG. 2, optionally, in another embodiment, the method further includes:
S4: Establishing a first coordinate system in the target entity model of the target physical entity. The origin of the first coordinate system remains fixed relative to the spatial position of the target entity model. The spatial attribute values of the part entity model of the part physical entity adopt the first coordinate system as a reference coordinate system; when the target entity model moves, the part entity model that has a parent-child relationship with the target entity model moves accordingly, and the relative positional relationship between the part entity model and the target entity model remains unchanged.

Specifically, a first coordinate system of the target entity model is established, and the target entity model is located in the first coordinate system, and the part entity model is located in the first coordinate system of its parent model.

When the target entity model is moved in the first coordinate system, the child model of the target entity model also uses the first coordinate system of its parent model as the reference coordinate system of the spatial range value, that is, the spatial range value of the part entity model is the coordinate value in the first coordinate system of the parent model of the part entity model. Through the settings of this embodiment, the relative spatial position association relationship between the target entity model and the part entity model can be quickly established. When the parent model with a parent-child relationship moves, its child models follow the movement of the parent model and the coordinate values of the target entity model and the child models thereof in the first coordinate system remain unchanged. When a child model of the target entity model moves, the grandchild model of the target entity model moves. The grandchild model of the target entity model moves along with the child model, and the coordinate values of the child model and the grandchild model in the first coordinate system change accordingly.

It should be noted that, as can be seen from the above, the part entity model can also be the parent model of other part entity models, that is, for the target entity model A, the part entity model B is a child model, or it can be the parent model of the part entity model C. From a view of the parent-child relationship of part entity model C, B is the target entity model. In the application of this embodiment, in a set of parent-child relationships, only the coordinate system of the parent model is paid attention to, and the coordinate system of the child model is ignored. Based on the constraint relationship between the parent model and the child model, the spatial position of child model is quickly moved by moving the spatial position of the target entity model associated with the child model.

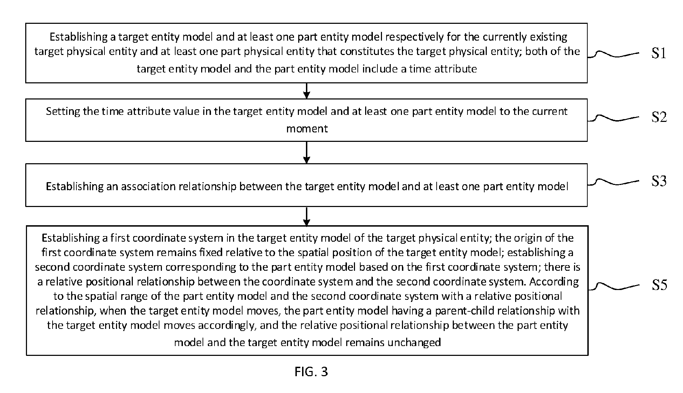

Referring to FIG. 3, optionally, in another implementation, the method further includes:
S5: Establishing a first coordinate system in the target entity model of the target physical entity; the origin of the first coordinate system remains fixed relative to the spatial position of the target entity model; establishing a second coordinate system corresponding to the part entity model based on the first coordinate system; there is a relative positional relationship between the coordinate system and the second coordinate system. According to the spatial range of the part entity model and the second coordinate system with a relative positional relationship, when the target entity model moves, the part entity model having a parent-child relationship with the target entity model moves accordingly, and the relative positional relationship between the part entity model and the target entity model remains unchanged.

Establishing the first coordinate system of the target entity model and the second coordinate system of the part entity model. By setting a relative position relationship between the first coordinate system of the target entity model and the second coordinate system of the part entity model that have a parent-child relationship, when the parent model of the parent-child relationship moves, the child model moves with the parent model. At this time, the coordinate value of the parent model relative to the first coordinate system remains unchanged, and the coordinate value of the child model relative to the second coordinate system also remains unchanged, and the relative position between the first coordinate system and the second coordinate system remains unchanged; when the parent model with a parent-child relationship does not move and the child model moves, the coordinate value of the child model relative to the second coordinate system remains unchanged, and the relative position between the first coordinate system and the second coordinate system changes as the child model moves. Through the settings of this embodiment, the child model can be moved according to the relative relationship between coordinate systems. In practical applications, taking factory modeling as an example, if a certain workshop is moved, the production line in the workshop will also move, which can quickly realize the effect of moving and deleting models.

Further, a first coordinate system of the target entity model is established, and a second coordinate system of the part entity model is established. Both the target entity model and the part entity model also include shape information. The shape information is the coordinate data of the target entity model describing the shape in the corresponding first coordinate system or the coordinate data of the part entity model describing the shape in the corresponding second coordinate system. The shape information of the entity model is described by the coordinate information in the coordinate system established. If the envelope information is only focused on, the envelope information can be set. If the specific shape information is focused on, the precise shape data within the coordinate system of the entity model can be set.

Further, a first coordinate system of the target entity model is established, and a second coordinate system of the part entity model is established. Both the target entity model and the part entity model also include posture information. The posture information describes the rotation posture of the entity model within its own coordinate system. Specifically it can be represented by the coordinate difference. In other embodiments, it can also be represented by the direction and angle of rotation of the rotation axis by setting a rotation axis on the entity model, which will not be described again here.

Optionally, in another implementation manner, the entity model adopts a unified data structure, that is, both the target entity model and the part entity model adopt a unified data structure.

The settings of this embodiment are suitable for digital twins of physical entities in most current industries by unifying the data structure of the entity model. In production applications, unified and fast digital twins of physical objects are realized, which is suitable for twins of all things.

Furthermore, the data elements in the unified data structure of the entity model at least include member information.

The member information is used to describe the difference information of different entity models. The entity model does not include the member information or includes at least one member information. The data structure of the member information can be set to include one data element or two data elements or multiple data elements according to the needs of the entity model.

For example, in an example of this embodiment, the data structure of the member information is set to include a member identification number (ID), member name, member data type, and member value. Take a car as an example. The color, material, weight, etc. of a car can be represented by the member information. In member information 1, the member ID is "1", the member name is "color", and the member data type is "enumeration". In member information 2, the member ID is "2", the member name is "material", and the member data type is "enumeration". In member information 3, the member ID is "3", the member name is "weight", and the member data type is "floating point", etc.

The member information is used to describe the differences between different entity models to meet the needs of different application scenarios, so that the data structure of a unified entity model meets the needs of digital twins of physical entities with differential information, increases the application scope of entity models with a unified data structure, and further applies to twins in all things.

Optionally, in another embodiment, after the target entity model is deleted, the part entity model that has a parent-child relationship is disassociated from the target entity model and is associated with the entity model of another physical entity. Alternatively, when the part entity model moves outside the spatial range of the target entity model, the association relationship with the target entity model is released.

In this embodiment, the method of establishing the parent-child relationship between the part entity model whose parent-child relationship is released and the target entity model whose spatial range includes the part entity model may be: when the target entity model whose parent-child relationship is released is not deleted, inheriting the spatial attribute value of the parent model of the part entity model before the parent-child relationship is released. The spatial attribute value of the parent model is the unique identifier of the target entity model that contains the parent model. The spatial range of the target entity model must include the spatial range of the part entity model. When the target entity model that releases the parent-child relationship is deleted, all entity models in the spatial range are retrieved and identified, and a tree diagram is established based on the parent-child relationship between the entity models, and the parent model of the target entity model that removes the parent-child relationship is found from the tree diagram. A parent-child relationship between the parent model and the part entity model whose parent-child relationship is released is established. In other implementations, other methods may be used, which will not be described again here.

Optionally, in another embodiment, the target entity model and the part entity model also include a type. The type is used to describe the category of the entity model. For example, the type of the part entity model A is car door, and the type of the part entity model B is car. cover, etc., the type is set so that users can know the category of the entity model in reality based on the type of the entity model.

Optionally, in another embodiment, the data structures of the target entity model and the part entity model at least include unique identification, type, time attribute, spatial attribute, position attribute, coordinate information, shape information, posture information and multiple member information. Through the settings of this embodiment, the entity model is suitable for physical object twins in most scenarios. The data structure of this embodiment has a wide range of application, and can reflect the characteristics of different industries and meet the needs of industrial production.

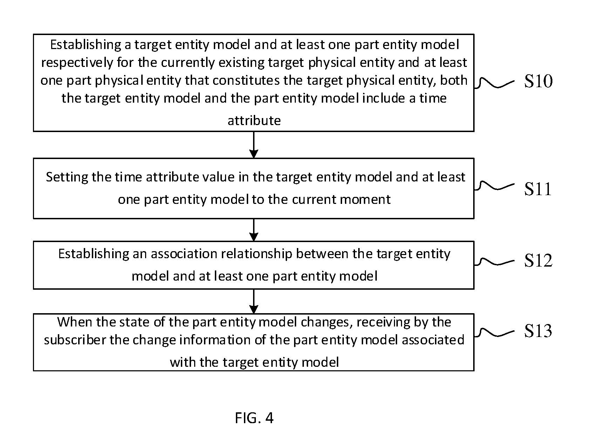

Referring to FIG. 4, in one embodiment of the present disclosure, a method for subscribing to the current state of an entity is provided, including the following steps:
S10: Establishing a target entity model and at least one part entity model respectively for the currently existing target physical entity and at least one part physical entity that constitutes the target physical entity, both the target entity model and the part entity model include a time attribute;
S11: Setting the time attribute value in the target entity model and at least one part entity model to the current moment;
S12: Establishing an association relationship between the target entity model and at least one part entity model;
S13: When the state of the part entity model changes, receiving by the subscriber the change information of the part entity model associated with the target entity model.

Specifically, in this embodiment, an association relationship between the target entity model and the part entity model is established, and the entity model is subscribed through the association relationship, thereby achieving the effect of accurately subscribing to associated entity models. In industrial production, there is a dependency and cooperation relationship between physical entities. The corresponding entity model is subscribed by the association relationship. When the associated entity model changes, the change of other entity models related to the changed entity model can be learned immediately.

In this embodiment, the state change of the part entity model includes any of the following situations: the attributes of the part entity model are modified, the part entity model is deleted from the associated target entity model. In other embodiments of present disclosure, it may also include the creation of a part entity model, etc., which will not be described in detail here. When the state of the part entity model changes, the subscriber can receive the change information of the child model in the target entity model based on the association relationship.

Further, the association relationship is data that reflects the relationship between entity models. The specific implementation can be the unique identifier, spatial attribute, location attribute, etc. in the attributes of the entity model.

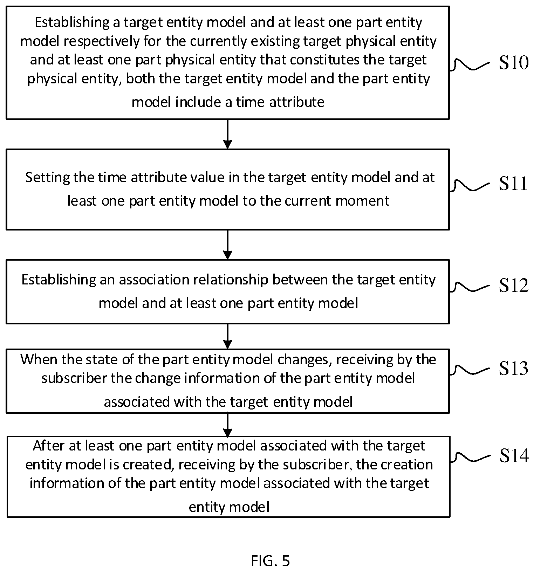

Referring to FIG. 5, optionally, in another embodiment, the method also includes:
S14: After at least one part entity model associated with the target entity model is created, receiving by the subscriber, the creation information of the part entity model associated with the target entity model.

Through the settings of this embodiment, information about the newly created part entity model can be received, and the life cycle of the target entity or part entity can be monitored. For example, taking factory production as an example, products processed in a certain workshop are part entity models having a parent-child relationship with the target entity model of the workshop. When the products are transported to the workshop for processing, the subscriber receives information about new products in the workshop, so that the products' production rate, output, processing state and other information can be monitored in real time to meet the needs of industrialization.

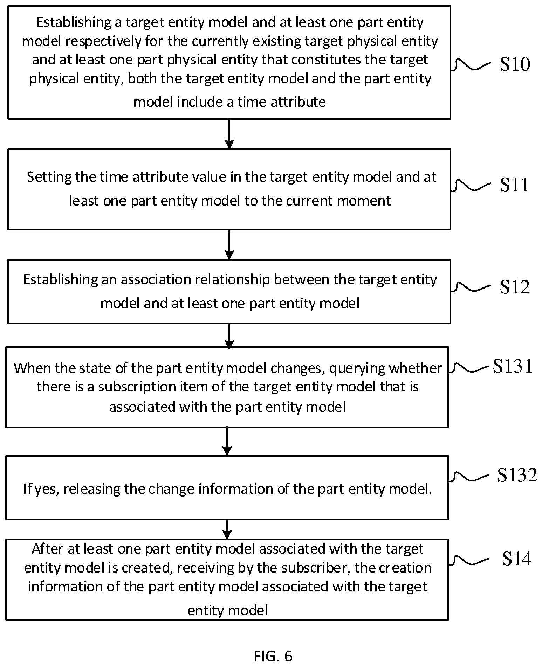

Referring to FIG. 6, optionally, in another implementation, S13 includes:
S131: When the state of the part entity model changes, querying whether there is a subscription item of the target entity model that is associated with the part entity model;
S132: If yes, releasing the change information of the part entity model.

During subscription, multiple subscription items are included in the subscription information according to different subscription information, and a certain subscription information subscribes to the change information of the part entity model associated with the target entity model that conforms to the subscription item.

Specifically, in this embodiment, by subscribing to the entity model based on the association relationship, the effect of accurately subscribing to the associated entity model can be achieved. In industrial production, there is a dependency and cooperation relationship between physical entities. The corresponding entity model is subscribed by the association relationship. When the associated entity model changes, the change of other entity models related to the changed entity model can be learned immediately.

Optionally, in another embodiment, the method also includes: generating subscription information from the association relationship between the target entity model and/or part entity model, or the association relationship and at least one other attribute value, and subscribing to the target entity model and/or the part entity model corresponding to the attribute value.

Specifically, in this embodiment, other attributes refer to other data elements in the data structure of the entity model other than association relationship, such as the time attribute, the shape information, etc.

When constructing subscription information, receiving the subscription content set by the subscriber and storing the subscription content as a subscription item, such as a unique identifier. The subscription information can also be generated from attributes from the perspective of the part entity model, such as spatial attributes. The subscription information can also be generated from the attributes of the target entity model and part entity model respectively, such as unique identification plus location attributes.

Further, filter conditions are set. After obtaining the subscription content, the subscription content is filtered according to the filter conditions.

Further, the subscription items of the subscription information at least include a unique identifier. When the spatial attribute value of a certain part entity model is modified, the subscription items with the same modified value of the spatial attribute are queried, and the part entity model change event is released.

The subscription items with the same value as the spatial attribute before modification, and the part entity model disassociation event is released.

An example of this embodiment is: the part entity model 1 is moved from the target entity model 2 to the target entity model 3. The subscription item of which the attribute value is the target entity model 3 is queried. If it is found in the query, the information about that the part entity model 1 is moved into the target entity model 3 is released. Moreover, the subscription item of which the unique identifier is the target entity model 2. If it is found, the information that part entity model 1 has moved out of the target entity model 2 is released.

Optionally**,** in another implementation, the subscription information adopts a unified data structure, and the contents of the subscription items in the subscription information are set according to actual production conditions.

Further, the subscription information includes unique identifiers, spatial attributes, location attributes, types, and filter conditions. This implementation method is suitable for subscription requirements in most industrial applications.

Further, in an example, when the subscription item in the subscription information includes a unique identifier, when modifying the attributes of the entity model, all subscription items whose unique identifier is the unique identifier of the entity model are queried. If there is a subscription item found in the query, the change information of the entity model will be released. If the entity model is deleted, the releasing process is the same as the modification, and the entity model deletion event is released.

Further, in an example, when the subscription items of subscribing information include spatial attributes and filter conditions, and the part entity model is added to the target entity model, it needs to be bound to the target entity model, that is, the spatial attribute value of the part entity model is set to the unique identifier of the target entity model, and all subscription items of which the space attribute value is the spatial attribute value of the part entity model are queried. If it is queried that there is a subscription item, the entity model corresponding to the subscription item can sense that a part entity model has been added. If it is queried that there are filter conditions in the subscription information corresponding to the subscription item and the field is not empty, it is judged whether the added part entity model meets the filtering conditions, if so, the unique identifier and name information of the added part entity model will be released, if not, it will not be released. If there is no filtering condition in the subscription information corresponding to the subscription item, the unique identifier and name information of the added part entity model will be released directly. When deleting the part entity model and modifying the attributes of the part entity model, such as modifying the content of member information, the process of releasing the change information of the part entity model is the same as the releasing process of adding the part entity model.

Further, in an example, the subscription items of the subscription information at least include a position attribute. When the position attribute value of a certain part entity model is modified, all subscription items of which the position attribute value is the same as the modified position attribute value are queried, the part entity model move-in event is released. All subscription items of which the position attribute value is the same as the position attribute before modification, and the part entity model move-out event is released.

When the subscription item information includes position attributes and filter conditions, after the position attribute value of the part entity model is modified, all subscription items of which position attribute is the current position attribute value of the entity model are queried. If the subscription information of the queried subscription item has filtering conditions, determining whether the object meets the filtering conditions. If yes, releasing that the part entity model moves in a new position, and the unique identifier and name information of the move-in part entity model. If not, it will not be released. If the filter condition of the subscription information in this subscription item is empty, it will be released directly. Querying all subscription items of which the position attribute value is the old position attribute value of the part entity model, if there are filter conditions in the subscription information corresponding to the subscription item, determining whether the part entity model meets the filter conditions, and if meets, releasing the information about that the part entity model moves out of the old position, the unique identifier and name information of the move-out part entity model; if does not meet, it will not release. If the filter condition is empty, it will be released directly.

Further, in one example, the subscription items of the subscription information at least include spatial attributes, types, and filter conditions. When the part entity model is added to the target entity model, it needs to be bound to the target entity model, that is, the spatial attribute value of the part entity model is set to the unique identifier of the target entity model. All subscription items of which spatial attributes are the spatial attribute values of the added part entity model. If the subscription item is queried and the type of the newly added part entity model is different from the type in the subscription information corresponding to the subscription item, then it will not be released. If the type of the newly added part entity model is the same as the type in the subscription information corresponding to the subscription item, it will be judged whether the part entity model meets the filter conditions in the queried subscription information. If meets, the unique identifier and name information of the created part entity model will be released, otherwise it will not be released. When deleting the part entity model and modifying the attributes of the part entity model, such as modifying member information, etc., the process of releasing the change information of the part entity model is the same as the process of adding the part entity model.

Further, in one example, the subscription items of the subscription information at least include position attributes, types, and filter conditions. When the position attribute of the part entity model is modified, querying all subscription items of which position attribute is the current position attribute value of the part entity model. If it is queried that there is a subscription item, and the type of the part entity model modified by the position attribute is different from the type in the subscription information corresponding to the queried subscription item, then it will not be released; if the type of the part entity model modified by the position attribute is the same as the type in the subscription information corresponding to the queried subscription item, and the subscription item of the subscription information has filter conditions, determining whether the part entity model modified by the position attribute satisfies the filtering conditions. If it meets the filtering conditions, then releasing information about that a part entity model moves in the new position and the unique identification and name information of the move-in part entity model. If not, it will not be released. Query all subscription items of which position attribute is the old location attribute value of the part entity model modified by the position attribute, if there is a subscription item queried, and the subscription information corresponding to the queried subscription item has filter conditions, determining whether the part entity model satisfies the filtering conditions of the subscription information, if yes, releasing information about that the part entity model moves out of the old position and the unique identifier and name information of the move-out part entity model; if not, it will not be released.

Further, in one example, the subscription items of the subscription information at least include a unique identifier, a spatial range, and a filtering condition. When the part entity model is added to the target entity model, it needs to be bound to the target entity model, that is, the spatial attribute value of the part entity model is set to the unique identifier of the target entity model. When a part entity model is added to a target entity model, querying all subscriptions that are uniquely identified by the spatial attribute values of that part entity model. If the subscription item is queried, the parent model of the part entity model is obtained, that is, the target entity model. In order to compare the relationship between the shape information of the part entity model and the spatial range, the shape information of the part entity model needs to be converted to the coordinate system of the target entity model, and then comparing the shape information with the spatial range of the target entity model. If the shape information of the part entity model does not meet the spatial range, it will not be released. if the shape information of the part entity model meets the spatial range, it will be judged whether the added part entity model satisfies the filter conditions in the subscription items, if yes, the unique identifier and name information of the created part entity model will be released, otherwise it will not be released. When deleting the part entity model and modifying the attributes of the part entity model, such as modifying member information, etc., the process of releasing the change information of the part entity model is the same as the process of adding the part entity model.

Further, the subscription items of the subscription information at least include a unique identifier, a spatial range, a type and a filtering condition. When the part entity model is added to the target entity model, it needs to be bound to the target entity model, that is, the spatial attribute value of the part entity model is set to the unique identifier of the target entity model. When the part entity model is added, querying all subscription items of which the unique identifier is the same as the spatial attribute value of the part entity model; if there are subscription items, the target entity model is obtained, and the coordinate system of the spatial range is the coordinate system of the target entity model; determining whether the part entity model conforms to the type of subscription information corresponding to the subscription item. If it does not match, it will not be released; if it does, in order to compare the relationship between the shape information of the part entity model and the spatial range, the shape information of the part entity model needs to be converted to the coordinate system of the target entity model, and then compared with the spatial range. If the shape information of the part entity model does not meet the spatial range, it will not be released; if the shape information of the part entity model satisfies the spatial range, the will be judged whether the part entity model meets the filtering conditions in the subscription item. If the filtering conditions are met, the unique identifier and name information of the created part entity model will be released. If not, it will not be released. When deleting the part entity model and modifying the attributes of the part entity model, such as modifying member information, etc., the process of releasing the change information of the part entity model is the same as the process of adding the part entity model.

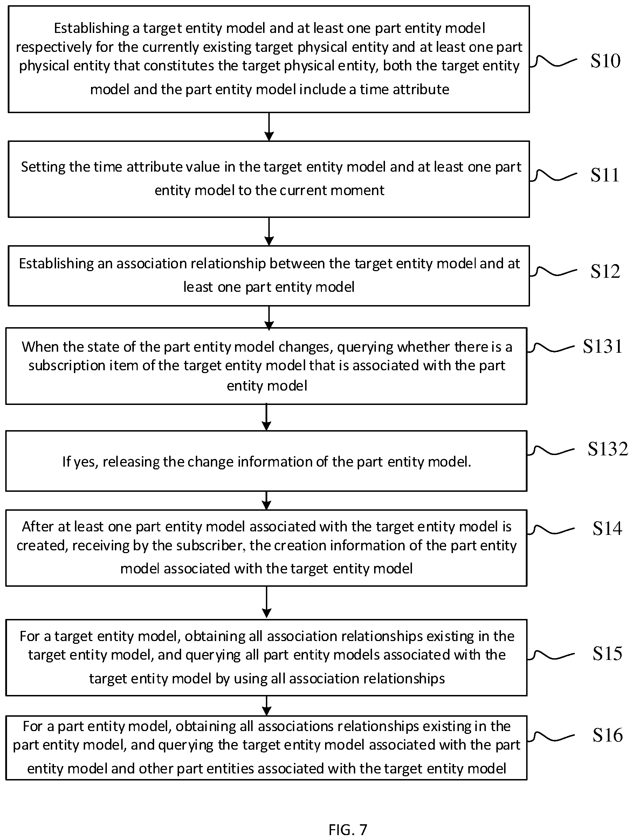

Referring to FIG. 7, optionally, in another embodiment, the method further includes:
S15: For a target entity model, obtaining all association relationships existing in the target entity model, and querying all part entity models associated with the target entity model by using all association relationships;
S16: For a part entity model, obtaining all associations relationships existing in the part entity model, and querying the target entity model associated with the part entity model and other part entities associated with the target entity model.

Specifically, in this embodiment, an association relationship is established between the target entity model and the part entity model, and the associated part entity model can be queried by querying the association relationship of a certain target entity model.

In an example of this implementation, after the association relationship is established, a tag is set for the parent model, and a tag associated with the parent model is set for the child model. The association relationship is established using tag association, and a certain target entity model is queried to obtain the association relationship represented on it. The tag is used to query all part entity models that match the tag to achieve a quick query effect.

If querying a tag of a certain part entity model for representing the association relationship, the target entity model associated with the tag and the part entity model associated with the target entity model will be found.

In this embodiment, the method of establishing an association relationship is not limited to tags. The association relationship may be established by an inclusion way of spatial position, etc. This is not the focus of this embodiment and will not be described in detail here.

Through the settings of present disclosure, querying the entity model through the association relationship, the required entity model can be quickly queried, and other models related to a certain entity model can also be queried.

Optionally, in another embodiment, an index is established based on the association relationship between the target entity model and/or the part entity model, or association relationship and at least one other attribute value, and the target entity model and/or the part entity model corresponding to the attribute value are queried.

Other attributes of the target entity model and part entity model are data elements in the data structures in addition to association relationships, such as time attributes, shape information, etc.

In this implementation, the indexing method is simple and does not require intermediate data conversion, which facilitates user queries and meets a variety of query needs. It does not only support key-value queries, but also makes users not need to worry about how to write the SQL statement in comparison with the Structured Query Language, SQL query, and can directly query according to the fixed method.

The index is established by the association relationship, and all related entity models can be directly queried based on the association relationship.

The index is established based on association relationships and other attributes, to query related entity models with the same attributes.

Further, setting filter conditions, and after obtaining the query results, filtering the query results according to the filter conditions.

Specifically, by setting filter conditions, the diverse needs of users can be met and accurate queries can be achieved.

The filter conditions support filtering of all attributes and member information fields. For example, first creating the target entity model "factory", and then creating the part entity model "production line". When a production line is created, its output is twinned as the "output" in the member information. Each production line continuously updates the member information "output" in real time during the production process. To find all production lines in the factory where the current output is greater than 1000, the filter condition can be written as "Output > 1000". After finding all the production lines of the factory based on the index, comparing the real-time value of the member information "output" in all the queried production lines to see if it meets the condition of being greater than 1000. After comparison, all production lines that meet this condition are returned. If not, the number of production lines returned is 0.

Further, in one example, an index is established based on the spatial attribute value to provide a query for a certain type of part entity model within the target entity model.

The spatial attribute value of the part entity model is the unique identifier of the target entity model to which it is bound. All part entity models with the same spatial attribute value are retrieved from the spatial attribute value. All queried part entity models are filtered according to the filter conditions. Finally, the data is organized according to the attribute fields required by the user, and the final result is returned to the user.

Further, in one example, an index is established based on the spatial attribute value and type to provide a query for a certain type of part entity model within the target entity model.

The spatial attribute value of the part entity model is the unique identifier of the target entity model bound to it. A joint index is established according to the spatial attribute and type. All part entity models with the same spatial attribute value and type are retrieved according to "spatial attribute + type". All queried part entity models are filtered according to the filter conditions. Finally, the data is organized according to the attribute fields required by the user, and the final result is returned to the user.

Further, in one example, an index is established based on the position attribute value to query the part entity model at this position of the target entity model.

The position attribute value of the part entity model is the unique identifier of the position at which the part entity model is located. That is, the position attribute value can also be queried to related entity models with associated relationships. An index is established according to the position attribute value, and all part entity models located at the same position are retrieved according to the position attribute. All queried part entity models are filtered according to the filter conditions. Finally, the data is organized according to the attribute fields required by the user, and the final result is returned to the user.

Further, in one example, an index is established based on the position attribute value and type to query a certain type of part entity model at the position of the target entity model.

The position attribute value of the part entity model is the unique identifier of the position at which the part entity model is located. A joint index is established according to the position attribute + type. All part entity models of same type at the same position are retrieved according to "position attribute + type". All queried part entity models are filtered according to the filter conditions. Finally, the data is organized according to the attribute fields required by the user, and the final result is returned to the user.

Further, in one example, an index is established based on the unique identifier and the spatial range to provide a query for the part entity model within a certain spatial range in the target entity model. The spatial range is the geometric range consisting of specific coordinate values on the coordinate system of the target entity model.

The unique identifier is the spatial attribute value of the part entity model associated with the target entity model. An index query is established based on the unique identifier, that is, an index is established based on the association relationship. The coordinate system of the query range is the coordinate system of the target entity model. The query range and the queried part entity model needs to be in the same coordinate system in order to use Z-space curve indexing technology. Therefore, the shape information of the part entity model located in the coordinate system of the aforementioned target entity model is converted to the coordinate system of the target entity model, and then the shape information and/or envelope information of the part entity model are converted into Z-space curve index range values and stored in the data structure of the part entity model. A joint index of the "unique identifier + Z curve index range value" of the target entity model is established. The query range is converted to the query range value under the Z-space curve. Then all part entity models that meet the conditions are retrieved according to "unique identification + query range". All queried part entity models are filtered according to the filter conditions. Finally, the data is organized according to the attribute fields required by users, and the final result is returned to users.

Further, in one example, an index is established based on the unique identifier, spatial range and type to query a certain type of part entity model within a certain spatial range in the target entity model. The spatial range is a spatial range composed of the specific coordinate values on the coordinate system of the target entity model.

The coordinate system of the query range is the coordinate system of the target entity model. The spatial range of the query and the queried part entity model need to be in the same coordinate system to facilitate the use of Z-space curve indexing technology, so the shape information of the part entity model is converted into in the coordinate system of the target entity model. The shape information and/or envelope information of the part entity model is converted into Z-space curve index range values, and stored in the data structure of the part entity model. A joint index of the "unique identifier + type + Z curve index range value" of the target entity model is established. The query range is converted to the query range value under the Z-space curve. Then all part entity models that meet the conditions are retrieved according to "unique identification + type + query range". All queried part entity models are filtered according to the filter conditions. Finally, the data is organized according to the attribute fields required by the user, and the final result is returned to the user.

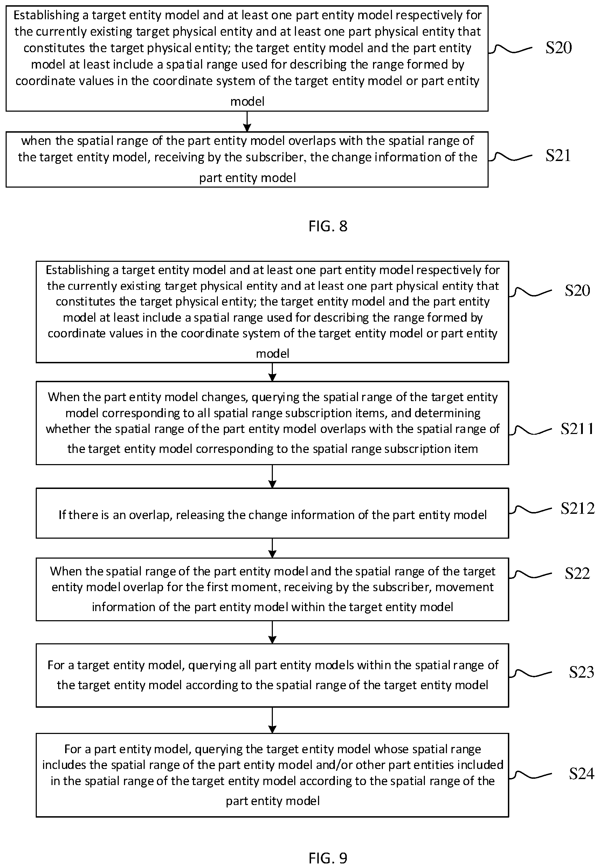

Referring to FIG. 8, in one embodiment of the present disclosure, a method for subscribing to the current state of an entity is provided, including the following steps:
S20: Establishing a target entity model and at least one part entity model respectively for the currently existing target physical entity and at least one part physical entity that constitutes the target physical entity; the target entity model and the part entity model at least include a spatial range used for describing the range formed by coordinate values in the coordinate system of the target entity model or part entity model;
S21: When the spatial range of the part entity model overlaps with the spatial range of the target entity model, receiving by the subscriber, the change information of the part entity model.

Specifically, in this embodiment, the coordinate system is established in advance. The method of establishing the coordinate system may include: 1. Establishing the first coordinate system of the target entity model, the spatial range value of the target entity model is the coordinate value in the first coordinate system, the spatial range value of the part entity model refers to the first coordinate system; 2. Establishing the first coordinate system of the target entity model, and establishing the second coordinate system of the part entity model; the first coordinate system and the second coordinate system have a relative position relationship. The relative position relationship in this embodiment is that the coordinates in the first coordinate system can be converted to the second coordinate system.

When the part entity model is moved into or created in the target entity model, if the spatial range of the part entity model partially coincides with the target entity model or the spatial range of the target entity model includes the spatial range of the part entity model, determining the relationship between the spatial range of the part entity model and the spatial range of the target entity model. It is required that the part entity model and the target entity model need to be converted to the same coordinate system.

Through the settings of this embodiment, the part entity model is associated with the target entity model due to the relationship between the spatial range of the part entity model and the spatial range of the target entity model. Through this association, the change information of part entity model associated with the target entity model can be quickly subscribed.

Referring to FIG. 9, optionally, in another embodiment, the method also includes:
S22: When the spatial range of the part entity model and the spatial range of the target entity model overlap for the first moment, receiving by the subscriber, movement information of the part entity model within the target entity model.

Optionally, in another implementation, S21 also includes:
S211: When the part entity model changes, querying the spatial range of the target entity model corresponding to all spatial range subscription items, and determining whether the spatial range of the part entity model overlaps with the spatial range of the target entity model corresponding to the spatial range subscription item;
S212: If there is an overlap, releasing the change information of the part entity model.

In this embodiment, the change of the part entity model includes any of the following situations: the attributes of the part entity model within the spatial range of the target entity model are modified, or the part entity model is moved out of the spatial range of the target entity model.

Optionally, in another embodiment, the method further includes:
S23: For a target entity model, querying all part entity models within the spatial range of the target entity model according to the spatial range of the target entity model;
S24: For a part entity model, querying the target entity model whose spatial range includes the spatial range of the part entity model and/or other part entities included in the spatial range of the target entity model according to the spatial range of the part entity model.

In one implementation, when the target object is the current event, the twinning method and subscription method of the current state of the target object provided by the embodiment of the present disclosure can be a twinning method and subscription method of the current state of the real-time event. Therefore, in the following explanation, a twinning method and subscription method of the current state of a real-time event will refer to the twin method and subscription method of the current state of the target object when the target object is the current event.

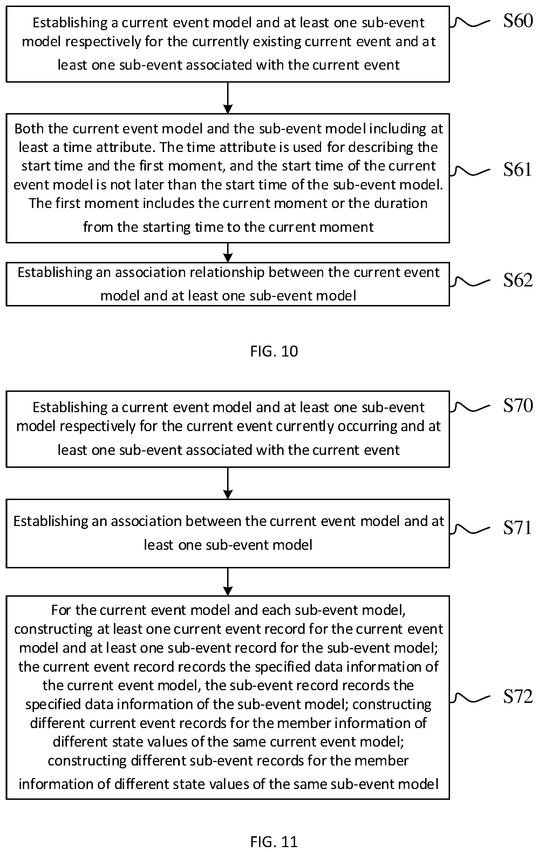

Referring to FIG. 10, in one embodiment of the present disclosure, a twinning method of current state of real-time events is provided. The main steps of the method are described as follows:
S60: Establishing a current event model and at least one sub-event model respectively for the currently existing current event and at least one sub-event associated with the current event;
S61: Both the current event model and the sub-event model including at least a time attribute. The time attribute is used for describing the start time and the first moment, and the start time of the current event model is not later than the start time of the sub-event model. The first moment includes the current moment or the duration from the starting time to the current moment;
S62: Establishing an association relationship between the current event model and at least one sub-event model.

The relationship between events is complicated. There may be a sequence between at least two events, or the duration range of one event includes another event, or the actual start time of a certain event affects the start of another event, etc., that is, events include leading events and subsequent events. The leading event is the event occurring first, and the subsequent event is the event that occurs after the leading event occurs. The subsequent event can occur within the duration of the leading event, or it can be that the actual start time of the leading event affects the start of subsequent events. In this embodiment, a current event model is established for the current event that currently exists and is a leading event, and a sub-event model is established for subsequent events (i.e., sub-events associated with the current event) of the current event. By constructing the association relationship between the current event model and sub-event models to express the intricate relationships between events and reduce the complexity of event model twins.

Specifically, in this embodiment, the way to establish the association relationship may be to set tags between the current event model and the associated sub-event model, or to set the attributes of the current event model or the sub-event model so that the current event model is associated with the sub-event model. In other implementations of present disclosure, other implementation methods of the related art can be adopted, which will not be described in detail here. By establishing the association relationship between the current event model and the associated sub-event model, users can query the current event model and sub-event model according to the association relationship to facilitate users to obtain the influence relationship between events.

Specifically, in this embodiment, the current event model and the sub-event model include at least a time attribute. The time attribute is used for describing the event starting time and the first moment. In this embodiment, the first moment is the current moment or the duration from the start time to the current moment. The current moment refers to the current moment when the attribute information of the current event model or sub-event model changes, and records the latest time when the event changes. The attribute value of the current moment can be modified synchronously when the current event model or sub-event model corresponding to the current moment is modified. The start time is the actual start time of the corresponding current event model or sub-event model. In this embodiment, the start time of the current event model is earlier than the start time of the associated sub-event model. Through the settings of present disclosure, the intricate relationships between the events are simplified into the sequential order relationship of start time, and the logic of establishing event models is simplified, and the event model establishment method of present disclosure is suitable for event model twins in various fields, such as industrial production, medical care, aerospace and aviation, etc. The event twinning method of the present disclosure is simple and can describe the relationship between events, make it easier for engineers to create event models and for users to view and understand.

Further, the duration time describes the duration of the corresponding current event model or sub-event model, and the duration of the current event model with a parent-child relationship is not less than the duration of the sub-event model.

Optionally, in another implementation, the current moment includes the current absolute time or the time of the most recent change.

In this embodiment, if the current event model or sub-event model corresponding to the event does not change at the current moment, the attribute value of the current moment is the absolute time of the current moment. If the current event model or sub-event model changes, the attribute value of the current moment is the current time when the current event model or sub-event model changes. Through the settings of present disclosure, the current event model or sub-event model obtained by users is the latest state of the corresponding event.

Optionally, in another embodiment, the association relationship is a parent-child relationship, the current event model with the parent-child relationship is the parent model, and the sub-event model is the child model. The relationship between the current event model and the associated child event model is a parent-child relationship. The parent-child relationship can better reflect the sequence between event models, as well as the master-slave relationship or inclusion between the current event model and the sub-event model. The complex relationships between events is expressed by using simple parent-child relationships.

Furthermore, in the parent-child relationship, the current event model is the only parent model of the sub-event model. The sub-event model is limited to have only one parent model, simplifying the relationship between events.

Optionally, in another embodiment, the sub-event model also includes a parent event model identifier. The parent event model identifier describes the current event model associated with the sub-event model. The association relationship between the sub-event model and the associated current event model are established through the parent event model identifier.

Optionally, in another embodiment, both the current event model and the sub-event model also include spatial attributes, which are used to describe the geographical location or geographical range in which the corresponding current event model or sub-event model occurs.

In practical applications, events are generated or formulated or executed by entity objects, that is, the geographical location of the events is at the geographical location of the entity objects. Spatial attributes are set for the current event model and sub-event models. From the spatial attributes, users can accurately know the area where the current event occurs. For example, in industrialized production, the current event is an alarm event in a certain factory, and the sub-event associated with the current moment is an alarm event in a workshop of the factory.

Further, the geographical location where the sub-event model occurs is within a predetermined range of the geographical location where the current event model occurs or the geographical range where the sub-event model occurs is within the geographical range where the current event model occurs.

When modeling an event, first establishing the current event model and setting spatial attributes for the current event model. The spatial attribute value can be the coordinate values of the entity object producing the event occurring in the coordinate system of the entity object corresponding to the current event or sub-event. At this time, the geographical location information of the current event model or sub-event model is formed by the space where the model pre-established by the entity object is located. For example, for a factory, establishing a factory model and establishing the first coordinate system corresponding to the factory model. The current event or the sub-event occurs in one of the workshop models of the factory model, then the geographical location information of the current event model or the sub-event model is the coordinate value of the workshop model in the first coordinate system established by the factory model. In other embodiments, the second coordinate system can also be established separately for the workshop model. At this time, the spatial attribute value is the relative position relationship between the second coordinate system and the first coordinate system. The geographical location where the sub-event model occurs is within the predetermined geographical location where the current event model occurs. The predetermined range is pre-set according to actual production needs, and the predetermined range can be a range formed by using the Global Positioning System (GPS) coordinates of the entity object corresponding to the current event model as the center extending to the surroundings or a range formed by extending the coordinate range of the current event model in the coordinate system outward or inward, and reflects the positional relationship between sub-events and the current event, which is convenient for industrial production. For example, an alarm event in a factory model is the current event, and an alarm event of the workshop model associated with the factory model is a sub-event model, and the geographical location of the factory includes the geographical location of the workshop.

The spatial attribute may also be the geographical range in which the corresponding sub-event model occurs. This geographical range is the geographical range in which the current event model with the parent-child relationship of the sub-event model occurs. For example, the spatial attribute of an alarm event in a certain factory is the geographical range of the factory where the alarm event is located. Optionally, in other embodiments, the spatial attribute value may also be the real-time positioning information of the entity object corresponding to the current event or sub-event, that is, it may be GPS positioning information or other real-time positioning information.

Optionally, in another implementation, both the current event model and the sub-event model also include entity identifiers, which describe entity objects that have a relationship with the current event model or the sub-event model.

Specifically, in this embodiment, the entity object that has a relationship with the current event model or sub-event model is the entity object that generates, formulates or executes the current event model or sub-event model.

Specifically, the entity identifier may be the name of the entity object that generates or formulates or executes the current event model or sub-event model. For example, in industrial production, such as a factory, the name of the factory is factory. The names of workshops in the factory are workshop 1, workshop 2, workshop 3, etc. Setting entity identifiers for the current event model and sub-event models. The entity identifier of the current event model corresponding to the factory is "factory", and the entity identifier of the sub-event model corresponding to workshop 1 is "workshop 1", the entity identifier of the sub-event model corresponding to workshop 2 is "workshop 2". The entity identifier associates the event with the entity object.

Further, the factory and the entity objects therein are modeled. The factory is the target entity model, and the workshop in the factory is the part entity model of the factory. Unique identifiers are set for both the target entity model and the part entity model. The entity identifiers are the unique identifiers of the entity object corresponding to the current event model or sub-event model, that is, the unique identifiers of the target entity model or part entity model. Through the settings of this embodiment, after the entity object and the event are modeled separately, the association relationship between entity objects and corresponding events is established through the entity identifiers.

Further, the attribute value of the parent event model identifier of the sub-event model having a parent-child relationship is the unique identifier of the current event model, which simplifies the way for establishing the association relationship between the sub-event model and the current event model.

Optionally, in another embodiment, both the current event model and the sub-event model also include member information, which describes the difference information of the current event model or the sub-event model.

Specifically, in this embodiment, the sub-event model and the current event model both use the same data structure, that is, a common data structure is set in advance. The data structure includes at least two attributes, including but not limited to: current moment attribute, start time attributes, duration, etc., and also includes member information. The member information includes difference information in the current event model or sub-event model. The difference information is information which is other than the predetermined attributes in the common data structure and needs to be recorded in the current event model or sub-event model. For example, the current event model or sub-event model is an alarm event. In addition to the start time attribute, current moment attribute, and duration, in industrial production, the person in charge, alarm threshold and other information which need to be known, can be represented by the member value in the member information. For example, if the current event model or sub-event model is production line information, in addition to the start time attribute, current moment attribute and duration, in actual production, the production line output, capacity consumption and other information which need to be known can be recorded in the member information.

Further, both the current event model and the sub-event model also include a type. The type describes the category of the current event model or sub-event model described by the member information, and the category is set according to the member information.

For example, the member information of current event model A includes the person in charge, alarm threshold, etc., which determines the category of current event model A as an alarm event. The member information of current event model B includes production line, output, etc., which determines the category of current event model B as a department-plan generation event, etc.

An example of this embodiment is as follows.

For example, a factory makes an annual plan, and the plan is broken down into various departments and turned into department plans. The company starts executing the annual plan, which is the parent event, and establish the current event model. The start time is 2021-01-01. The member information of the current event model has two member values, one is output and the other is energy consumption. The output is updated once a month, and the energy consumption is updated once a day. Each update of the energy consumption and the output only concerns to the update of the current time attribute. The associated entity object is the "entire factory". When the department starts executing the department plan, a sub-event model is created for the department sub-event. Multiple departments execute plans in parallel, and the members in the member information in the plan are consistent, such as planned output, daily output, number of people on the job, power consumption, etc. A sub-event model can be established, and a parent event model thereof is identified as the current event model. The sub-event model is not set with a start time, but only set with the member values of the member information of the current event model, that is, set with the values of planned output, daily output, number of people on the job, and power consumption etc. After department A starts executing the department plan, an event record A is created. The start time is 2021-02-01. After the department A completes all planned output on 2021-03-01, the event record ends and the event record is deleted. If the department B starts execution on 2021-02-15, an event record B will be created, the planned output will be completed on 2021-04-01, and the event record will be deleted. A current event model or sub-event model can have multiple event records.

Optionally, in another embodiment, both the current event model and the sub-event model also include a unique identifier, a name, a parent event model identifier, an entity identifier, a start time, a first moment, and member information.

Specifically, in this embodiment, a unified data structure is set for the current event model and the sub-event model. The attributes in the unified data structure include a unique identifier, a name, a parent event model identifier, an entity identifier, a start time, and a first moment and member information.

Specifically, the name is the name of the current event model or sub-event model, such as alarm event, output event, etc.

Through the settings of this embodiment, a data structure including a unique identifier, a name, a parent event model identifier, an entity identifier, a start time, a first moment and member information is adopted, which is suitable for most current industrial production event twins. In this embodiment, a unified data structure is used to implement event twinning, simplifying the event twinning process.

Referring to FIG. 11, in one embodiment of the present disclosure, a twinning method of current state of real-time events is provided, including the following steps:
S70: Establishing a current event model and at least one sub-event model respectively for the current event currently occurring and at least one sub-event associated with the current event;
S71: Establishing an association between the current event model and at least one sub-event model;
S72: For the current event model and each sub-event model, constructing at least one current event record for the current event model and at least one sub-event record for the sub-event model; the current event record records the specified data information of the current event model, the sub-event record records the specified data information of the sub-event model; constructing different current event records for the member information of different state values of the same current event model; constructing different sub-event records for the member information of different state values of the same sub-event model.

The event record includes a time attribute. The time attribute is used for describing the start time and the first moment. The first moment includes the current moment or the duration from the start time to the current moment, and the start time corresponding to the current event record is no later than the start time of the sub-event record.

Specifically, the current event record needs to specify the current event model, and the sub-event record needs to specify the sub-event model, which is used to record the specified current event model or sub-event model. In this implementation, when creating an event record, the current event record is assigned a unique identifier of the current event model, the sub-event record is assigned a unique identifier of the sub-event model, and the corresponding current event model or sub-event model is found based on the unique identifier. , obtain the member information of the current event model or sub-event model corresponding to the unique identifier.

In this embodiment, both the current event record and the sub-event record are provided with time attributes. The time attributes include the start time. The start time can be the absolute time when the current event record or sub-event record starts or the start moment of the corresponding current event model or the sub-event model. The start time of the sub-event record shall be later than the start time of the current event model associated with the corresponding sub-event model or the start time of the current event record of the current event model associated with the sub-event model.

The time attribute also includes a first moment. The first moment includes the current moment or the duration from the start time to the current moment. The current moment is the moment when the corresponding current event model or sub-event model attribute changes or the current absolute moment. The duration is the duration of the corresponding current event record or sub-event record.

Further, when creating the current event record or sub-event record, specifying the unique identifier of the current event model or sub-event model, and the different state values of the members in the member information of the current event model or sub-event model corresponding to the unique identifier. For example, specifying the current event model corresponding to the current event record, and the entity object corresponding to the current event model as the workshop. The different state values of the production line in the member information of the current event model include production line 1 and production line 2. When creating the event record, specifying that the state value of the member information recorded in the current event record as the production line 1, then specifying that the information corresponding to production line 1 is recorded in the current event record.

Further, the current event record has an associated relationship with any sub-event record.

Specifically, the association relationship between the current event record and any sub-event record is a parent-child relationship. In other embodiments of the present disclosure, the association relationship can be other associations, such as an affiliation relationship, a reference relationship, etc., which will not be limited here.

In this embodiment, taking the association relationship between the current event record and any sub-event record as a parent-child relationship as an example, the parent-child relationship between the current event record and the sub-event record inherits the parent-child relationship between the current event model corresponding to the current event record and the sub-event model corresponding to the sub-event record, that is, in the parent-child relationship, the current event record of the current event model serving as the parent model is the parent record of the sub-event record of the sub-event model.

In another embodiment of the present disclosure, the association relationship between the current event record and any sub-event record is a parent-child relationship, and the method for establishing a parent-child relationship between the current event record and the sub-event record is: after establishing the current event record, the current event record is given a name. If the name of the sub-event record created after the current event record is established is the same as the name of the current event record, the sub-event record is a sub-event of the current event record. In other embodiment of present disclosure, the parent-child relationship can be established by using existing methods, which will not be described in detail here.

Optionally, in another embodiment, when the duration of the sub-event record or the current event record ends, the current event record or sub-event record is deleted. Alternatively, both the current event record and the sub-event record include the end time, when the end time of the sub-event record or the current event record arrives, the sub-event record or the current event record is deleted.

Specifically, after the start time, the current event record or sub-event record starts to be created. Taking the current event record as an example, when the current event record ends, the end time is obtained, and the start time is subtracted from the end time to obtain the duration of the current event record, and then the current event record is deleted. Alternatively, after the duration elapses after the start time, the current event record is ended, and the current event record is deleted. The same procedure is implemented for sub-event records.

Further, in another embodiment, the current event record and the sub-event record are both provided with event record identifiers, and the event record identifier is used for uniquely identifying the corresponding current event record or sub-event record.

Further, a parent event record identifier is provided on the sub-event record. The parent event record identifier is the event record identifier of the current event record that has a parent-child relationship with the sub- event record. The parent-child relationship between the sub-event record and the current event record is established through the parent event record identifier set on the sub-event record.

Further, in another embodiment, when the current event record and the sub-event record are created, the current event model and the sub-event model are respectively specified, and the associated entity objects are set at the same time, that is, the current event record and the sub-event record are both set with entity object identifier of the associated entity object, so as to easily obtain the entity object corresponding to the current event record or sub-event record.

Further, in another embodiment, both the current event record and the sub-event record also include spatial attributes, and the spatial attributes are used for describing the geographical location or geographical range in which the corresponding current event model or sub-event model occurs. The geographical location where the sub-event model occurs is within a predetermined range of the geographical location where the current event model occurs or the geographical range where the sub-event model occurs is within the geographical range where the current event model occurs.

Specifically, in this embodiment, the spatial attributes of the current event record inherit the spatial attributes of its corresponding current event model, and the spatial attributes of the sub-event record inherit the spatial attributes of its corresponding sub-event model. In other embodiments of present disclosure, the spatial attributes of the current event record and sub-event record can also be customized during creation of the current event record and sub-event record.

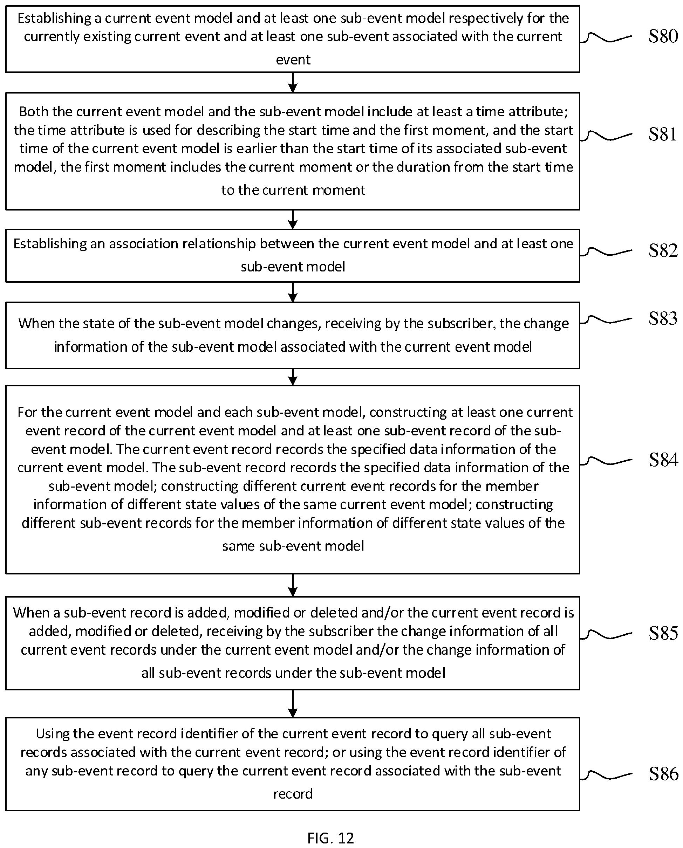

Referring to FIG. 12, in one embodiment of the present disclosure, a method for subscribing to the current state of real-time events is provided, including the following steps:
S80: Establishing a current event model and at least one sub-event model respectively for the currently existing current event and at least one sub-event associated with the current event;
S81: Both the current event model and the sub-event model include at least a time attribute; the time attribute is used for describing the start time and the first moment, and the start time of the current event model is earlier than the start time of its associated sub-event model, the first moment includes the current moment or the duration from the start time to the current moment;
S82: Establishing an association relationship between the current event model and at least one sub-event model;
S83: When the state of the sub-event model changes, receiving by the subscriber, the change information of the sub-event model associated with the current event model.

Specifically, in this embodiment, after the current event model and the sub-event model are established, and the association relationship between the current event model and the sub-event model is established, when subscribing to the current event model according to the required subscription information, the subscription method can be to create subscription information. The subscription information includes the subscription items that need to be subscribed. The unique identifier of the current event model is used as the subscription item. The information associated with the current event model is subscribed. When the sub-event model associated with the current event model changes, the subscriber can receive the change information of the sub-event model. If the current event model changes, the subscriber can also receive the change information of the current event model.

Further, after at least one sub-event model associated with the current event model is created, the subscriber receives the creation information of the sub-event model associated with the current event model.

Specifically, after the sub-event model is created, an association relationship is established between the sub-event model and the corresponding current event model. At this time, the subscriber receives the creation information of the sub-event model associated with the current event model. In this way, the birth of the sub-event model can be subscribed.

Optionally, in another implementation, S83 includes:
S831: When the state of the sub-event model changes, querying whether there is a subscription item of the current event model that is associated with the sub-event model;
S832: If yes, releasing the change information of the sub-event model.

In this embodiment, the change in the state of the sub-event model includes any of the following situations: the attributes of the sub-event model are modified, or the sub-event model is deleted from the associated current event model.

Furthermore, the subscription information includes filtering conditions, which can be set according to actual needs, such as limited start time, member information, etc.

When creating a sub-event model, the sub-event model is associated with the current event model, that is, the parent event model identifier of the sub-event model is modified to the unique identifier of the current event model, and all subscriptions item whose attribute values are the unique identifier are queried. If a subscription item is queried, obtaining the filtering conditions in the subscription information of the subscription item, determining whether the created sub-event model meets the filtering conditions, and if so, releasing the unique identifier and name of the created sub-event model. If not, then it will not be released. If there is no filter condition, the unique ID and name of the created sub-event model will be released directly. When modifying the attribute values of a sub-event model or deleting a sub-event model, the releasing process is the same as the above-mentioned addition process.

In other embodiments, the attribute value of the current event model or sub-event model can also be set as a subscription item in the subscription information to subscribe to changes in specific attributes of the current event model or sub-event model.

Optionally**,** in another embodiment, the method also includes:
S84: For the current event model and each sub-event model, constructing at least one current event record of the current event model and at least one sub-event record of the sub-event model. The current event record records the specified data information of the current event model. The sub-event record records the specified data information of the sub-event model; constructing different current event records for the member information of different state values of the same current event model; constructing different sub-event records for the member information of different state values of the same sub-event model;
S85: When a sub-event record is added, modified or deleted and/or the current event record is added, modified or deleted, receiving by the subscriber the change information of all current event records under the current event model and/or the change information of all sub-event records under the sub-event model.

Specifically**,** in this embodiment, the current event record is set with the unique identifier of the specified current event model, and the sub-event record is set with the unique identifier of the specified sub-event model. When there is a subscription item with the corresponding unique identifier, the current event record corresponding to the current event model or the sub-event record corresponding to the sub-event model can be associated and subscribed.

In the following, the event record is used to refer to the current event record or sub-event record to facilitate a detailed explanation of the solution of the present disclosure and should not be understood as a limitation of the present disclosure.

Optionally, in another embodiment, the current event model or sub-event model is queried, and all queried event records under the current event model or sub-event model are associated.

An example of this embodiment is as follows: a real-time library receives a subscription request. The subscription request includes subscription information. The subscription items in the subscription information include unique identifiers and filter conditions. When an event record is created, it needs to be specified by the current event model or sub-event model, that is, specifying the unique identifier of the current event model or sub-event model on the event record, and then querying all subscription items whose attribute values are the unique identifier. If the subscription item is queried, obtaining the filter conditions in the subscription information corresponding to the subscription item, if there are filter conditions, determining whether the created event record satisfies the filter conditions. If so, the ID and name of the created event record will be released. If not, it will not be released. If there are no filter conditions in the subscription information, the event record ID and name of the created event record will be released directly. After the event recording is completed, the releasing process of deleting the event record is the same as the aforementioned adding process. When the member value of the event record is modified, the releasing process is the same as the aforementioned adding process.

Optionally, in another embodiment, the real-time library receives a subscription request. The subscription information includes entity identifier and filtering conditions. When an event record is created, specifying an entity identifier and querying all subscription items whose attribute values are the entity identifiers. If a subscription item is found, obtaining the filter conditions in the subscription information corresponding to the subscription item; determining Whether the created event record satisfies the filter condition, if so, the event record ID and name of the created event record will be released, if not, it will not be released. If there is no filter condition, the event record ID and name of the created event record will be released directly. After the end of the event record, the releasing process of deleting the event record is the same as the aforementioned adding process. when the member value of the event record is modified, the releasing process is the same as the aforementioned adding process.

Optionally, in another embodiment, the current event record has an association relationship with any sub-event record.

Specifically, in this embodiment, the association relationship between the current event record and the sub-event record is a parent-child relationship. In other embodiments of present disclosure, it may also be other relationships, such as an affiliation relationship.

Optionally, in another embodiment, both the current event record and the sub-event record also include event record identifiers, and the method includes:
S86: Using the event record identifier of the current event record to query all sub-event records associated with the current event record; or using the event record identifier of any sub-event record to query the current event record associated with the sub-event record.

Specifically, in this embodiment, the event record identifier of the current event record is used to establish an index, so that all sub-event records associated with the current event record can be associated and queried. The specific method may include that the recorded event record ID of the associated current event record recorded on the sub-event record is the parent event record ID. In other embodiments of the present disclosure, it is also possible to set associated tags between the current event record and its associated sub-event records. When searching using the event record identifier of the current event record, the sub-event record is automatically found through the associated tags. In other embodiment of present disclosure, there are other related query methods, which will not be described in detail here.

Using the event record identifier of any sub-event record, the association relationship is used to automatically query the current event record associated with the sub-event record. The specific correlation query method can be to obtain the parent event record identifier on the sub-event record by querying the sub-event record so as to find the current event record associated with the sub-event record. In other embodiments of present disclosure, there are other associated query methods, which will not be described again here.

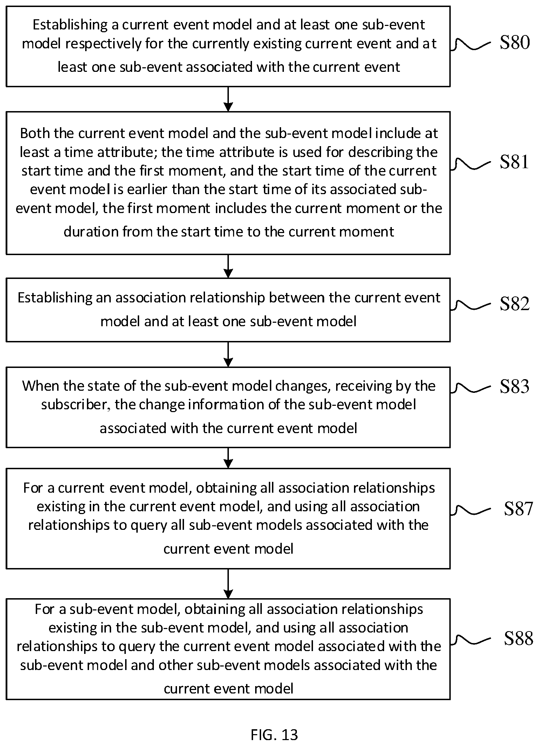

Referring to FIG. 13, optionally, in another embodiment, the method further includes:
S87: For a current event model, obtaining all association relationships existing in the current event model, and using all association relationships to query all sub-event models associated with the current event model;
S88: For a sub-event model, obtaining all association relationships existing in the sub-event model, and using all association relationships to query the current event model associated with the sub-event model and other sub-event models associated with the current event model.

Further, an index is established based on association relationship of the current event model and/or sub-event model or the association relationship and the attribute value of at least one attribute, and the current event model and/or sub-event model corresponding to the attribute value is queried.

Specifically, in this embodiment, an index can be established to obtain the attribute values of the current event model or sub-event model through association relationship query to query related models. For example, an index is established based on the unique identifier of the current event model, the current event model and the sub-event model whose unique identifier is the unique identifier of the parent event model can be retrieved, thereby realizing fast query.

Further, when establishing an index query, he filter conditions are set. The filter conditions may be entity identifiers, start times, etc. The entity identifiers of the current event model and the child event model with a parent-child relationship may be different.

Further, by establishing an index according to the parent event model identifier and filtering conditions, all sub-event models associated with the current event model whose unique identifier is the parent event model identifier can be retrieved, and it is judged whether the retrieved sub-event models satisfy the filtering conditions, and then information that satisfies the filtering conditions is organized and sorted according to the attribute fields required by users, and returned to the users. If there are no filtering conditions, all retrieved sub-event models are directly organized and sorted according to the attribute fields required by the users, and returned to the users.

Further, by establishing an index according to the parent event model identifier, types and filtering conditions, querying a certain type of sub-event model in the sub-event model associated with the parent event model identifier, and determining whether the retrieved sub-event model satisfies the filtering conditions, and the information that satisfies the filtering conditions is organized and sorted according to the attribute fields required by the user and returned to the users. If there are no filter conditions, all the retrieved sub-event models are directly organized and sorted according to the attribute fields required by the users and returned to the users.

Further, by establishing an index according to the unique identifier and filtering conditions, query all event records of the current event model or sub-event model corresponding to the unique identifier, determining whether the retrieved event records satisfy the filtering conditions, and the information that satisfies the filtering conditions is organized and sorted according to the attribute fields required by users and returned to the users. If there are no filter conditions, all the retrieved event records are directly organized and sorted according to the attribute fields required by the users and returned to the users.

Further, by establishing an index according to the entity identifier and filtering conditions, querying the event records related to the entity corresponding to the entity identifier, determining whether the queried event records satisfy the filtering conditions, and the information that satisfies the filtering conditions is organized and sorted according to the attribute fields required by the users and returned to the users. If there are no filter conditions, all retrieved event records will be directly organized and sorted according to the attribute fields required by the users and returned to the users.

Furthermore, by establishing an index based on the entity identifier and/or unique identifier can also search for the current event model, sub-event model, and event records of the entity, and return information based on the filter conditions and user requirements.

It should be understood that the sequence number of each step in the above embodiments does not mean the order of execution. The execution order of each process should be determined by its function and internal logic, and should not constitute any limitation on the implementation process of the embodiments of the present disclosure.

Based on the same concept of a twinning method for the current state of a target object provided in the embodiments of the present disclosure, some embodiments of the present disclosure provides a twinning system for the current state of a target object. The system includes:
a model building module configured to respectively establish a target object model and at least one sub-target object model for the currently existing target object and at least one sub-target object that constitutes the target object;
an association-relationship establishment module configured to establish an association relationship between the target object model and at least one sub-target object model.

Further, when the target object is a target physical entity, the twinning system of the current state of the target object can correspond one-to-one to the twinning method of the current state of the entity in the above embodiments. The system includes:
a model building module configured to establish a target entity model and at least one part entity model respectively for the currently existing target physical entity and at least one part physical entity that constitutes the target physical entity. The target entity model and the part entity model are both Includes a time attribute;
an attribute setting module configured to set a value of the time attribute of the target entity model and at least one part entity model to the current moment;
an association-relationship establishment module configure to establish an association relationship between the target entity model and at least one part entity model.

Furthermore, when the target object is a current event, the twinning system of the current state of the target object can correspond one-to-one with the twinning method of the current state of the real-time event in the above embodiments. The system includes:
a model building module configured to respectively establish a current event model and at least one sub-event model for the currently existing current event and at least one sub-event associated with the current event;
an attribute setting module configured to set a time attribute. Both the current event model and the sub-event model at least include the time attribute. The time attribute is used for describing the start time and the first moment, and the start time of the current event model is not later than the start time of the sub-event model. The first moment includes the current moment or the duration from the start time to the current moment;
an association-relationship establishment module configured to establish an association relationship between the current event model and at least one sub-event model.

In one embodiment of the present disclosure, when the target object is a current event, a twinning system of the current state of the target object is also provided. The system includes:
a model building module configured to respectively establish a current event model and at least one sub-event model for the current event currently occurring and at least one sub-event associated with the current event;
an association-relationship establishment module configured to establish an association relationship between the current event model and at least one sub-event model;
an event record building module configured to construct at least one current event record of the current event model and at least one sub-event record of the sub-event model for the current event model and each sub-event model, and the current event record records the data information of the specified current event model, the data information of the sub-event model specified by the sub-event record; constructing different current event records for member information of different state values of the same current event model; constructing different sub-event records for the member information of different state vales of the same sub-event model.

The event record includes a time attribute. The time attribute is used for describing the start time and the first moment. The first moment includes the current moment or the duration from the start time to the current moment, and the start time of the current event record is no later than the start time of the sub-event record.

Each module of the twinning system of the current state of the target object mentioned above can be realized in whole or in part through software, hardware and their combination. Each of the above modules may be embedded in or independent of the processor of the computer device in the form of hardware, or may be stored in the memory of the computer device in the form of software, so that the processor can call and execute the operations corresponding to the above modules.

Based on the same concept of a method for subscribing to the current state of a target object provided in the embodiments of the present disclosure, some embodiments of the present disclosure provide a system for subscribing to the current state of a target object. The system includes:
a model building module configured to respectively establish a target object model and at least one sub-target object model for the currently existing target object and at least one sub-target object that constitutes the target object;
a releasing module configured for the subscriber to receive the change information of the sub-target model associated with the target object model when the state of the sub-target object model changes.

Further, when the target object is a target physical entity, the subscription system for the current state of the target object can correspond one-to-one with the subscription method for the current state of the entity in the above embodiments. The system includes:
a model building module configured to establish a target entity model and at least one part entity model respectively for the currently existing target physical entity and at least one part physical entity that constitutes the target physical entity. The target entity model and the part entity model are both includes a time attribute;
an attribute setting module configured to set a value of the time attribute value of the target entity model and at least one part entity model to the current moment;
an association-relationship establishment module configured to establish an association relationship between the target entity model and at least one part entity model;
a first releasing module configured for the subscriber to receive the change information of the part entity model associated with the target entity model when the state of the part entity model changes.

Further, in another embodiment, the first releasing module is also configured for the subscriber to receive the creation information of the part entity model associated with the target entity model after the creation of at least one part entity model associated with the target entity model is completed.

Further, in another embodiment, the first releasing module is also configured to query whether there is a subscription item of the target entity model that is associated with the part entity model when the state of the part entity model changes; if so, release the change information of the part entity model.

Further, in another embodiment, the state change of the part entity model includes any of the following situations: the attributes of the part entity model are modified, or the part entity model is deleted from the associated target entity model.

Further, in another embodiment, the system further includes a first query module configured to obtain all association relationships existing in the target entity model, and use all association relationships to query all part entity models associated with the target entity model according to;
a second query module configured to obtain all association relationships existing in a part entity model, and use all association relationships to query the target entity model associated with the part entity model and other part entity models associated with the target entity model.

Each module of the above-mentioned subscription system for the current state of physical objects can be implemented in whole or in part through software, hardware, and combinations thereof. Each of the above modules may be embedded in or independent of the processor of the computer device in the form of hardware, or may be stored in the memory of the computer device in the form of software, so that the processor can call and execute the operations corresponding to the above modules.

In one embodiment of the present disclosure, a subscription system for the current state of an entity is provided. The subscription system for the current state of an entity corresponds to the subscription method for the current state of an entity in the above embodiment in a one-to-one manner. The subscription system for the current state of the entity includes:
a model building module configured to respectively establish a target entity model and at least one part entity model for the currently existing target physical entity and at least one part physical entity that constitutes the target physical entity. The target entity model and the part entity model at least include a spatial range. The spatial range is used for describing the range formed by coordinate values in the coordinate system of the target entity model or part entity model;
a second releasing module configured for the subscriber to receive the change information of the part entity model when the spatial range of the part entity model overlaps with the spatial range of the target entity model.

Further, in another embodiment, the second releasing module is also configured to for the subscriber to receive the information of the part entity model moving in the target entity model when the spatial range of the part entity model first overlaps the spatial range of the target entity model.

Further, in another embodiment, the second releasing module is also configured to query the spatial range of the target entity model corresponding to all spatial range subscription items when the part entity model changes, and determine whether the spatial range of the part entity model overlaps with the spatial range of the target entity model corresponding to the spatial range subscription item; if there is overlap, release the change information of the part entity model.

Further, in another embodiment, the change of the part entity model includes any of the following situations: the attributes of the part entity model within the spatial range of the target entity model are modified, or the part entity model is moved out of the spatial range of the target entity model.

Further, in another embodiment, the system further includes:
a fourth query module configured to query all part entity models within the spatial range of a target entity model according to the spatial range of the target entity model;
a fifth query module configured to query a target entity model whose spatial range includes the spatial range of the part entity model and/or other part entity models included in the spatial range of the target entity model includes the according to the spatial range of the part entity model.

Each module of the above-mentioned subscription system for the current state of physical objects can be implemented in whole or in part through software, hardware, and combinations thereof. Each of the above modules may be embedded in or independent of the processor of the computer device in the form of hardware, or may be stored in the memory of the computer device in the form of software, so that the processor can call and execute the operations corresponding to the above modules.

In one embodiment of the present disclosure, when the target object is a current event, the subscription system for the current state of the target object can correspond one-to-one with the subscription method for the current state of the real-time event in the above embodiment. The system includes:
a model building module configured to respectively establish a current event model and at least one sub-event model for the currently existing current event and at least one sub-event associated with the current event;
an attribute setting module configured to set a time attribute. Both the current event model and the sub-event model at least include a time attribute. The time attribute is used for describing the start time and the first moment, and the start time of the current event model is earlier than the start time of the sub-event model associated with the current event model, the first moment includes the current moment or the duration from the start time to the current moment;
an association-relationship establishment module configured to establish an association relationship between the current event model and at least one sub-event model;
a releasing module configured for the subscriber to receive the change information of the sub-event model associated with the current event model when the state of the sub-event model changes.

Further, in another embodiment, the releasing module is also configured for the subscriber to receive the creation information of the sub-event model associated with the current event model after the creation of at least one sub-event model associated with the current event model is completed.

Further, in another embodiment, the releasing module is also configured to query whether there are subscription items of the current event model that are associated with the sub-event model when the state of the sub-event model changes; if so, release change information of the sub-event model.

Further, in another embodiment, the state change of the sub-event model includes any of the following situations: the attributes of the sub-event model are modified, the sub-event model is deleted from the associated current event model.

Further, in another embodiment, the system further includes:
an event record building module configured to construct at least one current event record of the current event model and at least one sub-event record of the sub-event model for the current event model and each sub-event model, and the current event record records the data information of the specified event model, the sub-event record records the data information of the specified sub-event model; construct different current event records for member information of different state values of the same current event model; construct different sub-event records for the member information of different states values of the same sub-event model.

The releasing module is also configured for the subscriber to receive the change information of all current event records under the current event model and/or the change information of all sub-event records under the sub-event model, when the sub-event records are added, modified or deleted and/or the current event records are added, modified or deleted.

Further, in another embodiment, the system further includes:
a first query module configured to obtain all association relationships in a current event model, and query all sub-event models associated with the current event model by using the association relationships;
a second query module configured to obtain all association relationships in a sub-event model, and query a current event model associated with the sub-event model and other sub-event models associated with the current event model by using the association relationships.

Further, in another embodiment, an index is established based on the association relationship of the current event model and/or sub-event model or the association relationships and the attribute value of at least one attribute, and the current event model and/or sub-event model corresponding to the attribute value is queried.

Further, in another embodiment, the system further includes a model building module configured to query the current event model or sub-event model, and associate and query all event records under the current event model or sub-event model.

Further, in another embodiment, the current event record has an associated relationship with any sub-event record.

Further, in another embodiment, both the current event record and the sub-event record also include event record identifiers, and the method further includes:
querying all sub-event records associated with the current event record by using the event record identifier of the current event record; or querying the current event record associated with the sub-event record by using the event record identifier of any sub-event record.

Each module of the subscription system for the current state of the target object mentioned above can be implemented in whole or in part by software, hardware and combinations thereof. Each of the above modules may be embedded in or independent of the processor of the computer device in the form of hardware, or may be stored in the memory of the computer device in the form of software, so that the processor can call and execute the operations corresponding to the above modules.

In one embodiment of the present disclosure, a computer-readable storage medium is provided. The computer-readable storage medium stores a computer program. When the computer program is executed by a processor, the twinning method for current state of target object and/or subscription method for current state of target object described in the above embodiment is realized.

Those skilled in the art can clearly understand that for the convenience and simplicity of description, only the division of the above functional units and modules is used as an example. In actual applications, the above functions can be allocated to different functional units and modules according to needs, that is, the internal structure of the system described in present disclosure are divided into different functional units or modules to complete all or part of the functions described above.

## Claims

1. A twinning method of a current state of a target object, comprising:
establishing a target object model and at least one sub-target object model respectively for a target object and at least one sub-target object that constitutes the target object;
establishing an association relationship between the target object model and at least one sub-target object model.

2. The method according to claim 1, wherein the association relationship is a parent-child relationship, the target object model in the parent-child relationship is a parent model, and a sub-target object model in the parent-child relationship is a child model.

3. The method according to claim 2, wherein in the parent-child relationship, the target object model is a unique parent model of the sub-target object model.

4. The method according to any one of claims 1 to 3, wherein the target object is a target physical entity, the target object model is a target entity model; the sub-target object is a part physical entity, and the sub-target object model is a part entity model;
both the target entity model and the part entity model comprises a time attribute;
assigning a value of the time attribute in the target entity model and at least one part entity model with a current moment.

5. The method according to claim 4, wherein both the target entity model and the part entity model comprise a spatial attribute describing a spatial size of the target entity model or the part entity model.

6. The method according to claim 5, wherein the spatial attribute is described by a spatial range for describing a geometric range formed by coordinate values of the target entity model or the part entity model in a coordinate system;
a spatial range of the part entity model of the part physical entity with the parent-child relationship is less than or equal to a spatial range of the target entity model of the target physical entity.

7. The method according to claim 5, wherein the target entity model and the part entity model further comprise a unique identifier for uniquely mapping to a corresponding target entity model or a corresponding part entity model.

8. The method of claim 6, further comprising:
in the target entity model of the target physical entity, establishing a first coordinate system, wherein an origin of the first coordinate system remains fixed relative to a spatial position of the target entity model; a value of the spatial attribute of the part entity model of the part physical entity adopt the first coordinate system as a reference coordinate system;
in a case that the target entity model moves, the part entity model that comprises the parent-child relationship with the target entity model moves along with the target entity model.

9. The method of claim 6, further comprising:
in the target entity model of the target physical entity, establishing a first coordinate system, wherein an origin of the first coordinate system remains fixed relative to a spatial position of the target entity model;
establishing a second coordinate system corresponding to the part entity model based on the first coordinate system; wherein there is a relative positional relationship between the first coordinate system and the second coordinate system;
wherein in a case that the target entity model moves, the part entity model that comprises the parent-child relationship with the target entity model moves accordingly based on the spatial range of the part entity model and the second coordinate system with a relative positional relationship.

10. The method according to claim 5, wherein the part entity model further comprises a position attribute; the position attribute is used for describing any spatial range of the part entity model other than the spatial range of the part entity model within a spatial range of the target entity model that comprises the parent-child relationship with the part entity model.

11. The method according to claim 10, wherein in a case of the part entity model moving, modifying a value of the position attribute of the part entity model to be a unique identifier of another part entity model corresponding to a spatial range to which the part entity model needs to be moved.

12. The method of claim 6, further comprising:
wherein both the target entity model and the part entity model comprise shape information and posture information, and the shape information is coordinate data describing a shape of the target entity model in the first coordinate system or coordinate data describing a shape of the part entity model in the second coordinate system; the posture information describes data describing a rotation of the target entity model in the first coordinate system or data describing a rotation of the part entity model in the second coordinate system.

13. The method of claim 3, further comprising:
after the target entity model is deleted, disassociating the part entity model that comprises the parent-child relationship with the target entity model from the target entity model;
or
in a case that the part entity model moves outside a spatial range of the target entity model, disassociating the part entity model from the target entity model.

14. The method according to claim 2, wherein both the target entity model and the part entity model further comprises member information for describing difference information of the target entity model or the part entity model.

15. The method according to claim 3, wherein the target object is a current event, and the target object model is a current event model; the sub-target object is a sub-event, and the sub-target object model is a sub-event model;
both the current event model and the sub-event model comprise at least a time attribute for describing a start time and a first moment, the start time of the current event model is no later than the start time of the sub-event model; the first moment comprises the current moment, or represents a duration from the start time to the current moment.

16. The method according to claim 15, wherein the duration describes a duration of a the current event model or a duration of the sub-event model, and the duration of the current event model that comprises the parent-child relationship with the sub-event model is not less than the duration of the sub-event model.

17. The method according to claim 15, wherein both the current event model and the sub-event model further comprise an entity identifier for describing an entity object associated with the current event model or the sub-event model.

18. The method according to claim 15, wherein both the current event model and the sub-event model further comprise member information for describing difference information of the current event model or difference information of the sub-event model.

19. The method according to any one of claims 16 to 18, wherein both the current event model and the sub-event model further comprise a type for describing a category of the current event model described by the member information or a category of the sub-event model described by the member information; wherein the category is set based on the member information.

20. The method according to claim 1, wherein the target object is a current event, and the target object model is a current event model; the sub-target object is a sub-event, and the sub-target object model is a sub-event model; wherein the method further comprises:
for the current event model and each sub-event model, constructing at least one current event record of the current event model and at least one sub-event record of the sub-event model, wherein specified data information of the current event model is recorded in the at least one current event record, specified data information of the sub-event model is recorded in the at least one sub-event record; constructing different current event records for member information of different state values of a same current event model; constructing different sub-event records for member information of different state values of a same sub-event model;
wherein an event record comprises a time attribute for describing a start time and a first moment; the first moment comprises a current moment or a duration from the start time to the current moment, and the start time of the current event record is no later than the start time of the sub-event recording.

21. The method according to claim 20, wherein the current event record comprises an associated relationship with any sub-event record.

22. The method according to claim 20, wherein both the current event record and the sub-event record further comprise an event record identifier for uniquely identifying the current event record or the sub-event record.

23. The method according to any one of claims 15 and 20-22, wherein both the current event model and the sub-event model further comprise a spatial attribute, and the spatial attribute describes a geographical location or geographic range where a corresponding current event model or sub-event model occurs.

24. The method according to claim 23, wherein the geographical location where the sub-event model occurs is within a predetermined range of the geographical location where the current event model occurs, or a geographical range where the sub-event model occurs is within a geographical range where the current event model occurs.

25. A method for subscribing to a current state of a target object, comprising:
establishing a target object model and at least one sub-target object model respectively for a target object and at least one sub-target object that constitutes the target object;
in a case that a state of the sub-target object model changes, receiving by a subscriber, change information of the sub-target model associated with the target object model.

26. The method according to claim 25, wherein the target object is a target physical entity, and the target object model is a target entity model; the sub-target object is a part physical entity, and the sub-target object model is a part entity model;
both the target entity model and the part entity model comprise a time attribute;
assigning a value of the time attribute of the target entity model and at least one part entity model to a current moment;
before the receiving by the subscriber, the change information of the sub-target model associated with the target object model, the method further comprises:
establishing an association relationship between the target entity model and at least one part entity model.

27. The method according to claim 26, further comprising:
after at least one part entity model associated with the target entity model is created, receiving by the subscriber, creation information of the part entity model associated with the target entity model.

28. The method according to claim 26 or 27, wherein in a case that the state of the part entity model changes, receiving by the subscriber, the change information of the part entity model associated with the target entity model, comprises:
in a case that the state of the part entity model changes, querying whether there is a subscription item of the target entity model that is associated with the part entity model;
releasing the change information of the part entity model in response to there being the subscription item.

29. The method according to claim 26, wherein the state of the part entity model changing, comprises any of the following situations: an attribute of the part entity model is modified, or the part entity model is deleted from the target entity model associated with the part entity model.

30. The method according to claim 26, further comprising:
for the target entity model, obtaining all association relationships existing in the target entity model, and querying all part entity models associated with the target entity model by using the all association relationships;
for the part entity model, obtaining all association relationships existing in the part entity model, and querying the target entity model associated with the part entity model and other part entity models associated with the target entity model by using the all association relationships.

31. The method according to claim 25, wherein the target object is a target physical entity, and the target object model is a target entity model; the sub-target object is a part physical entity, and the sub-target object model is a part entity model;
wherein the target entity model and the part entity model at least comprise a spatial range for describing a range of the target entity model or the part entity model formed by coordinate values in a coordinate system;
in a case that the state of the sub-target object model changes, receiving by the subscriber, the change information of the sub-target model associated with the target object model, comprises:
in a case that a spatial range of the part entity model overlaps with a spatial range of the target entity model, receiving by the subscriber, the change information of the part entity model.

32. The method according to claim 31, wherein in a case that the spatial range of the part entity model overlaps with the spatial range of the target entity model, receiving by the subscriber, the change information of the part entity model within the target entity model, comprises:
in a case that the spatial range of the part entity model first overlaps the spatial range of the target entity model, receiving by the subscriber, information about the part entity model moving into the target entity model.

33. The method according to claim 31 or 32, wherein in a case that the spatial range of the part entity model overlaps with the spatial range of the target entity model, receiving by the subscriber, the change information of the part entity model within the target entity model, comprises:
in a case that the part entity model changes, querying the spatial range of the target entity model corresponding to a subscription item of all spatial ranges, and determining whether the spatial range of the part entity model overlaps with the spatial range of the target entity model corresponding to the subscription item of the all spatial ranges;
releasing the change information of the part entity model of in response to the spatial range of the part entity model overlapping with the spatial range of the target entity model corresponding to the subscription item of the all spatial ranges.

34. The method according to claim 33, wherein the part entity model changing comprises any of the following situations: an attribute of the part entity model within the spatial range of the target entity model is modified, or the part entity model is moved out of the spatial range of target entity model.

35. The method according to claim 31, further comprising:
for the target entity model, query all part entity models within the spatial range of the target entity model according to the spatial range of the target entity model;
for the part entity model, querying the target entity model whose spatial range comprises the spatial range of the part entity model, and/or querying other part entity models comprised in the spatial range of the target entity model according to the spatial range of the part entity model.

36. The method according to claim 25, wherein the target object is a current event, and the target object model is a current event model; the sub-target object is a sub-event, and the sub-target object model is a sub-event model;
both the current event model and the sub-event model comprise at least a time attribute for describing a start time and a first moment, and the start time of the current event model is earlier than the start time of the sub-event model associated with the current event model; the first moment comprises a current moment or a duration from the start time to the current moment;
before the receiving by the subscriber, the change information of the sub-target model associated with the target object model, the method further comprises:
establishing an association relationship between the current event model and at least one sub-event model.

37. The method according to claim 36, further comprising:
after at least one sub-event model associated with the current event model is created, receiving by the subscriber, creation information of the sub-event model associated with the current event model.

38. The method according to claim 36 or 37, wherein in a case that a state of the sub-event model changes, receiving by the subscriber, the change information of the sub-event model associated with the current event model, comprises:
in a case that the state of the sub-event model changes, querying whether there is a subscription item of the current event model associated with the sub-event model;
releasing the change information of the sub-event model in response to there being the subscription item of the current event model associated with the sub-event model.

39. The method according to claim 36, wherein the state of the sub-event model changing comprises any of the following situations: an attribute of the sub-event model is modified, or the sub-event model is deleted from the current event model associated with the sub-event model.

40. The method according to claim 38, further comprising:
for the current event model and each sub-event model, constructing at least one current event record of the current event model and at least one sub-event record of the sub-event model, wherein specified data information of the current event model is recorded in the at least one current event record, specified data information of the sub-event model is recorded in the at least one sub-event record; constructing different current event records for member information of different state values of a same current event model; constructing different sub-event records for member information of different state values of a same sub-event model;
in a case that the at least one sub-event record is added, modified or deleted and/or the at least one current event record is added, modified or deleted, receiving by the subscriber, change information of all current event records of the current event model and/or change information of all sub-event records of the sub-event model.

41. The method according to claim 38, further comprising:
for the current event model, obtaining all association relationships of the current event model, and querying all sub-event models associated with the current event model by using the all association relationships;
for the sub-event model, obtaining all association relationships of the sub-event model, and querying the current event model associated with the sub-event model and other sub-event models associated with the current event model, by using the all association relationships.

42. The method according to claim 38, further comprising:
creating an index based on the association relationships of the current event model and/or sub-event models, or based on the association relationships and an attribute value of at least one attribute, and querying a current event model and/or a sub-event model corresponding to the attribute value.

43. The method according to claim 38, further comprising:
querying the current event model or the sub-event model, and associating all event records of queried current event model or queried sub-event model.

44. The method according to claim 40, wherein the current event record comprises an association relationship with any sub-event record.

45. The method according to claim 44, wherein both the current event record and the sub-event record further comprise an event record identifier, and the method further comprises:
querying all sub-event records associated with the current event record by using the event record identifier of the current event record; or,
querying the current event record associated with any sub-event record by using the event record identifier of the any sub-event record.

46. A twinning system of a current state of a target object, comprising:
a model building module configured to establish a target object model and at least one sub-target object model respectively for a target object and at least one sub-target object that constitutes the target object;
an association-relationship establishment module configured to establish an association relationship between the target object model and the at least one sub-target object model.

47. A system for subscribing to a current state of a target object, comprising:
a model building module configured to establish a target object model and at least one sub-target object model respectively for a target object and at least one sub-target object that constitutes the target object;
a releasing module configured for a subscriber to receive change information of the sub-target model associated with the target object model in response to a state of the sub-target object model changing.

48. A computer-readable storage medium, storing a computer program, and in response to the computer program being executed by a processor, steps of the method described in any one of claims 1 to 45 are implemented.
